# EUROPEAN PATENT SPECIFICATION

(11) **EP 2 502 728 B1**
(45) Date of publication and mention of the grant of the patent: **04.01.2017**
(21) Application number: 11160803.0
(22) Date of filing: 01.04.2011
(51) Int. Cl.: B29C 67/00, G03F 7/004, G03F 7/00, G03F 7/027, G03F 7/038, B29K 105/16

(54) **Lightweight and high strength three-dimensional articles producible by additive fabrication processes**
Leichte und hochfeste, mittels Additivherstellungsverfahren erzeugbare dreidimensionale Artikel
Articles tridimensionnels légers et résistants pouvant être produits par des procédés de fabrication additive

(30) Priority: 23.03.2011 US 466766 P
(43) Date of publication of application: 26.09.2012
(73) Proprietor: DSM IP Assets B.V., 6411 TE Heerlen (NL)
(72) Inventor: Ren, Kangtai, Geneva, IL 60134 (US); East, Samuel, Lake in the Hills, IL 60156 (US); Bauman, Brian, Liberty Hill, TX 78642 (US); Hoiss, Anna, 83104 Hohenthann (DE)
(74) Representative: V.O.

(56) References cited:
- EP-A1- 0 393 676
- EP-A1- 1 382 434
- WO-A1-2007/138619
- US-A1- 2001 025 203

## Description

### Field of the Invention

The present invention relates to three-dimensional articles formable from liquid radiation curable resins using additive fabrication processes.

### Background of the Invention

Materials with the lightweight quality of thermoplastics and the strength and stiffness of metals are highly desirable in a variety of industries. An example of materials that have a desirable combination of low weight, high strength, and high stiffness are carbon fiber composites. To form such a material into a useful shape requires the use of a mold. Molds are expensive to produce and can therefore present a barrier to the use of low weight, high strength, high stiffness materials when parts are required in low production amounts because even the production of a single part requires an expensive mold to be designed and constructed. Moreover, design iteration of such parts is generally not feasible since a change in the design may require that an entirely new mold be constructed, adding time and great expense to the design process.

Because of the expense of producing production quality parts, the industry has turned to rapid prototyping technologies to produce high quality low cost parts and prototypes in limited volumes. An example of a rapid prototyping process is an additive fabrication process. Additive fabrication processes utilize computer-aided design (CAD) data of an object to build three-dimensional parts layer-by-layer. These three-dimensional parts may be formed from liquid resins, powders, or other materials.

A non-limiting example of an additive fabrication process is stereolithography (SL). Stereolithography is a well-known process for rapidly producing models, prototypes, patterns, and production parts in certain applications. SL uses CAD data of an object wherein the data is transformed into thin cross sections of a three-dimensional object. The data is loaded into a computer which controls a laser beam that traces the pattern of a cross section through a liquid radiation curable resin composition contained in a vat, solidifying a thin layer of the resin corresponding to the cross section. The solidified layer is recoated with liquid resin and the laser beam traces another cross section to harden another layer of resin on top of the previous layer. The process is repeated layer by layer until the three-dimensional object is completed. When initially formed, the three-dimensional object is, in general, not fully cured and therefore may be subjected to post curing, if required. An example of an SL process is described in U.S. Patent No. 4,575,330.

Certain additive fabrication processes require a liquid radiation curable resin for forming three-dimensional objects that can be solidified by light energy. Typically, liquid radiation curable resins are cured by ultra-violet (UV) light. Such light is typically produced by lasers (as in stereolithography), lamps, or light emitting diodes (LEDs). The delivery of energy by a laser in a stereolithography system can be Continuous Wave (CW) or Q-switched pulses. CW lasers provide continuous laser energy and can be used in a high speed scanning process.

Some additive fabrication technologies are able to produce parts with the dimensional accuracy of molds that possess mechanical properties which are similar to thermoplastics, but do not approach the high strength and stiffness of metals. For some time liquid radiation curable resins for additive fabrication, including distinct subsets of additive fabrication such as stereolithography, have employed inorganic filler to increase the strength and stiffness of three-dimensional articles made from the liquid radiation curable resin. In all known commercial embodiments of such inorganically filled resins, for instance SOMOS^{®} NanoTool™ and SOMOS^{®} NanoForm™, available from DSM, and Accura^{®} Bluestone™, available from 3D Systems, the liquid radiation curable resin comprises a high amount of dense silica filler. The use of silica fillers in stereolithographic resins are described in, for example, US2004/0137368, assigned to 3D Systems, Inc. Dense silica filler allows for the production of three-dimensional articles that possess high strength and stiffness, but also possess very high density. For instance, the typical solid density of the solid material formed from such liquid radiation curable resins is relatively high, typically from about 1.3 g/cm³ to about 1.8 g/cm³. Furthermore, such products lack sufficient toughness and/or are too brittle for some applications, such as certain wind tunnel testing applications and use as injection molds.

In order to improve the toughness of three-dimensional articles made from additive fabrication processes, metal coating and cladding techniques were developed. Such metallization techniques are known in the art. Please see, for instance, Saleh et al, "Effects of Electroplating on the Mechanical Properties of Stereolithography and Laser Sintered Parts," Rapid Prototyping Journal, Volume 10, Number 5, 2004, or Shine et al, "Effect of Surface Preparation Methods on Mechanical Properties of 3D Structures Fabricated by Stereolithography and 3D Printing for Electroless Ni Plating," Proceedings of the 2007 Solid Freeform Fabrication Symposium, Austin TX, August 6-8, 2007. Commercial metallization processes are offered in the industry, for instance, by RePliForm Incorporated.

Because three-dimensional articles produced by rapid prototyping processes usually have very smooth surfaces, a series of pretreatment steps are required so that the metal coating adheres to the three-dimensional article sufficiently. Generally, three steps are required: pickling, sensitization, and activation. The pickling step is order to create cavities, and in some cases modify the chemistry, on the surface of the three-dimensional article thereby improving the adherence of the coating. The pickling step has generally been performed by sanding the surface of the three-dimensional article, but chemical etching may also be used. See US Patent 7354870 for a description of a chemical etching process. Chemical etching may damage the resin surface and affect the polymer network by chemical reaction, thereby reducing the integrity of the three-dimensional article. Consequently, physical processes such as sanding or sandblasting are preferred for the pickling step. However, liquid radiation curable resins that comprise dense silica particles are relatively difficult to sand. This difficulty is especially prevalent in areas of high surface detail and fine features. Consequently, it would be useful to have a liquid radiation curable resin for additive fabrication with high strength and stiffness that is easier to sand than liquid radiation curable resins which comprise dense silica.

As mentioned, even additive fabrication processes that are able to produce parts with relatively high strength and stiffness do so with materials that are relatively high in density compared to other three-dimensional articles produced via rapid prototyping processes. Moreover, parts that are high strength and high stiffness usually possess low toughness or high brittleness. Furthermore, current three-dimensional articles producible by additive fabrication processes present some difficulty when performing a metallization process that increases the toughness of the three-dimensional article. It would therefore be desirable to have a three-dimensional article capable of being formed using an additive fabrication process that possesses high strength, high stiffness, and low density and produces high quality metalized articles when subjected to a metal coating process. EP 0 393 676 A1 discloses a stereolithography process using glass bubbles as fillers.

### Summary of the Invention

The first aspect of the instant claimed invention is a three-dimensional article having a plastic core and a metal shell, according to claim 1.

The second aspect of the instant claimed invention is a process for making a three-dimensional article according to claim 14.

### Detailed Description of the Invention

The first aspect of the instant claimed invention is a three-dimensional article having a plastic core and a metal shell, according to claim 1.

Since the three-dimensional articles are formed via an additive fabrication process, the use of an expensive mold is not required. Any suitable additive fabrication process may be used to form the three-dimensional articles. Any suitable light source can be used to form the three-dimensional articles from the liquid radiation curable resin, for instance, a laser, an LED, or a lamp. In an embodiment, a laser is used as the light source. In an embodiment, the plastic core is formed using a stereolithography process. In another embodiment, the light source is one or more LEDs. Moreover, the liquid radiation curable resins can be formed with the aid of any suitable apparatus, for instance, the liquid radiation curable resins can be imaged within a vat or imaged on a substrate, such as a radiation transparent film.

The liquid radiation curable resins for additive fabrication used to form the three-dimensional objects have sufficiently low viscosity, in some embodiments despite high filler content, and are capable of being cured into three-dimensional articles of low density and that form high quality parts after being subjected to a metal coating process. The three-dimensional articles possess high strength, high stiffness, low density, and high toughness, and can be formed without the use of expensive molds. Additionally, in some embodiments the low viscosity of the liquid radiation curable resins allow for a sufficiently rapid additive fabrication process.

The three-dimensional articles have low density while still achieving high strength and stiffness. Solid density as used throughout this patent application means the solid density of the plastic core material, irrespective of any specific geometry features. For instance, the solid density of a plastic core formed as a solid cube has the same solid density as a plastic core formed as a hollow cube if both plastic cores are made of the same material. In embodiments, the solid density of the plastic core is less than 1.00 g/cm³, in other embodiments less than 0.90 g/cm³. In another embodiment, the solid density of the plastic core is less than about 0.80 g/cm³. In other embodiments, the three-dimensional articles have plastic cores with a solid density from 0.60 g/cm³ to 1.00 g/cm³, and in further embodiments from 0.60 g/cm³ to 0.90 g/cm³. In some embodiments, the solid density of the plastic core is from about 0.75 g/cm³ to about 0.90 g/cm³. In contrast, typical unfilled liquid radiation curable resins for additive fabrication form three-dimensional articles with a solid density of greater than 1.10 g/cm³. Liquid radiation curable resins that contain inorganic filler in greater than 20 wt% of the entire formulation typically form three-dimensional articles that have a solid density of greater than about 1.3 g/cm³ and often greater than 1.6 g/cm³.

In an embodiment, the liquid density of the liquid radiation curable resin is less than 1.0 g/cm³, in other embodiments less than 0.90 g/cm³. In other embodiments, the liquid radiation curable resins have a liquid density of from 0.60 g/cm³ to 1.00 g/cm³, and in further embodiments from 0.60 g/cm³ to 0.90 g/cm³. In some embodiments, the liquid density is from about 0.75 g/cm³ to about 0.90 g/cm³. In contrast, typical unfilled liquid radiation curable resins for additive fabrication have liquid densities of greater than 1.10 g/cm³.

In further embodiments, the liquid radiation curable resin has a dynamic viscosity below 5 Pa.s (5000 cps) 30 °C. In further embodiments the liquid radiation curable resin has a dynamic viscosity at 30 °C of less than 4 Pa.s (4000 cps), and in other embodiments less than 3 Pa.s (3000 cps). In other embodiments, the liquid radiation curable resin has a viscosity of from about 2.8 to 5 Pa.s (2800 to 5000 cps), or from 2.8 to 4 Pa.s (2800 to 4000 cps).

The three-dimensional articles possess excellent tensile strength and tensile modulus. In an embodiment, the three-dimensional articles possess a tensile strength of greater than about 90 MPa and a tensile modulus of greater than about 25 GPa. In other embodiments, the three-dimensional articles posses tensile strengths from about 90 MPa to about 250 MPa, or from about 90 MPa to about 200 MPa. In embodiments, the three-dimensional articles possess tensile strengths of from about 90 MPa to about 150 MPa. In further embodiments, the three-dimensional articles possess a tensile modulus of from about 25 GPa to about 100 GPa, or from about 25 GPa to about 80 GPa, and in further embodiments from about 25 GPa to about 60 GPa. In other embodiments, the three-dimensional articles posses a tensile modulus from about 50 GPa to about 100 GPa., or from about 50 GPa to about 80 GPa, and in further embodiments from about 50 GPa to about 60 GPa.

Because of the low density plastic core and the metal coating, the discovered three-dimensional articles have an excellent strength to weight ratio. Typically, such a strength to weight ratio have been reserved for molded parts, rather than parts formed via an additive fabrication process.

According to the invention, the claimed three-dimensional articles have a plastic core that is formed from a liquid radiation curable resin that comprises from 10 wt% to 35 wt%, more preferably from about 10 wt% to about 25 wt%, of filler. According to the invention, the inorganic filler has a density of less than 1.0 g/cm³, more preferably less than 0.75 g/cm³ and is surface treated glass bubbles. Surface treated glass bubbles are also known as surface treated hollow glass microspheres. In another embodiment, the surface treated glass bubbles are surface treated with a silane, such as epoxy silane or amino silane. Prior to surface treatment, the glass bubbles should be washed with ethanol. Examples of silane surface treatments are cyclohexyl epoxysilane, H₃PO₄, methacryloxypropyltrimethoxysilane, 2-(3,4-epoxycyclohexyl)ethyltrimethoxysilane, or 3-(trimethoxysilyl)propyl glycidyl ether.

Glass bubbles, which may or may not be surface treated, are commercially available from 3M™ as, for example, 3M™ Glass Bubbles H50/10000 EPX or H20/1000, A16/500. A20/1000, D32/4500 or 3M™ iM30K Hi-Strength Glass Bubbles. Other examples of suitable materials are 3M™ Glass Bubbles General Purpose Series and 3M™ Hollow Ceramic Microspheres. Further examples are from Potters Industries Inc. as Sphericel^{®} Hollow Glass Spheres with/without Coupling Agents, such as 110P8, 110P8-CP1, 110P8-CP2 or 110P8-CP3. In an embodiment, the glass bubbles are a soda lime borosilicate glass.

In an embodiment, the surface treated glass bubbles have an average particle size of less than 100 microns. In another embodiment, the surface treated glass bubbles have an average particle size of less than 50 microns. In embodiments, the surface treated glass bubbles have an average particle size of from about 0.1 micron to about 100 microns. In other embodiments, the surface treated glass bubbles have an average particle size of from about 0.1 micron to about 50 microns. The measurement of the particle size of the glass bubble component can be accomplished by using, for example, a dynamic light scattering analysis system. An example of such a system is the LB-550 machine, available from Horiba Instruments, Inc. Information regarding multiple particle size analysis techniques can be found at http://www.horibalab.com/page.php?id=674. A preferred method of measuring particle size is laser diffraction particle size analysis in accordance with ISO13320:2009. Information regarding such analysis can be found in Setting New Standards for Laser Diffraction Particle Size Analysis, Alan Rawle and Paul Kippax, Laboratory Instrumentation News, January 21, 2010.

Certain problems can arise when attempting the form liquid radiation curable resins for additive fabrication that contain inorganic filler into low density three-dimensional articles. Because an additive fabrication process involves curing one layer of liquid radiation curable resin for additive fabrication at a time, each layer of the liquid radiation curable resin must have nearly identical chemical makeup. Consequently, phase separation in the liquid radiation curable resin can be detrimental to the quality of the three-dimensional articles produced via an additive fabrication process. Depending on the density of the surface treated glass bubbles and the viscosity or thixotropic properties of the other components of the liquid radiation curable resin for additive fabrication, a thickener, such as a thixotropic and/or anti-floating agent, may be required to keep the liquid radiation curable resin for additive fabrication from exhibiting phase separation. Consequently, a relatively high amount, in comparison to conventional liquid radiation curable resins for additive fabrication, of a thixotropic agent may be used to control the floating of the surface treated glass bubble component. In embodiments, this thixotropic agent may comprise from about 0.1 wt% to about 5.0 wt% of the entire liquid radiation curable resin for additive fabrication. In an embodiment, the thixotropic agent is a hydrophilic or hydrophobic fumed silica component, for instance Aerosil^{®} 200, 300, 90, 130, 150, 380, R202, R805, R812, R974, R7200, R8200 and R9200, sold by Evonik Industries. In other embodiments, the thixotropic agent may be Thixcin^{®} R, Thixcin^{®} E, Thixatrol^{®} ST or Thixatrol^{®} UV1104 etc, sold by Elementis Specialties (U.S); Garamite^{®} LS, 2578, 1958 or 1210 etc, sold by Southern Clay Products; BYK^{®}-410, or/and R-605, sold by BYK-Chemie USA; Disparlon^{®} 6700, F9050 sold by King Industries; Crayvallac Super sold by Cary Valley Ltd. Occasional vat circulation or remixing may be desirable for some liquid radiation curable resin formulations to avoid filler floating.

The metal shell on top of the plastic core may be formed using any appropriate metallization process such as coating or electroforming (also known as electroplating). In an embodiment, an electroplating process is used. Electroplating involves the use of an anode and a cathode in a solution. A potential difference is applied between the anode and cathode, thereby coating the cathode in metal. Any suitable metal can be used to form the metal shell.

Typically a base layer is applied to the plastic core, followed by an outer layer. In an embodiment, the thickness of the base layer of the metal shell is from about 1 to about 100 µm. The purpose of the base layer is to form a strong adherence to the plastic core while allowing for a sufficient bond with the outer layers. In an embodiment, the base layer material is copper, silver, or nickel. A copper or silver base layer may be formed using a vapor deposition process. A copper or nickel base layer may be formed using an electroless deposition process. In an embodiment, the metal shell comprises a base layer, preferably comprising copper or nickel, with a thickness of from about 1 µm to about 100 µm.

Once the base layer is dry, the outer layer is formed over the base layer. In an embodiment, a copper base layer is first applied to the plastic core and then the copper base is further plated with a nickel outer layer. In another embodiment, a nickel base layer is first applied to the plastic core before being plated with a nickel outer layer. In other embodiments, the outer layer may be chromium, copper, or alloys. Alloys may include, for example, alloys of copper, nickel, chromium, magnesium, aluminum, zinc, other metals, and/or nonmetals.

In an embodiment, the metal shell comprises from about 5 % to about 30 % by volume of the three-dimensional article. There are multiple ways to determine the metal volume percentage of a three-dimensional article. One possible method is to merely determine the volume to-be-plated area of the plastic core prior to plating, determining the volume of the plated three-dimensional article, and then determining the percentage difference. Another possible method is to measure the dimensions of the plastic core prior to plating at various locations in order to determine the cross-sectional area at those locations, measuring the dimensions at those same locations after plating to determine the cross-sectional area after plating, and then determining the percentage difference. In other embodiments, the metal shell comprises from about 5 % to about 20 % by volume of the plastic core. In further embodiments, the metal shell comprises from about 10 % to about 20 % by volume of the plastic core.

In an embodiment thickness of the metal shell is from about 0.05 mm to about 3.0 mm in thickness. In another embodiment, the metal shell is from about 0.05 mm to about 1.5 mm.

As previously stated, the three-dimensional articles of the instant invention possess high strength and stiffness. The ideal failure of a metalized three-dimensional article that has a plastic core formed from a liquid radiation curable resin for additive fabrication is a full crack across both the plastic core and the metal shell. This indicates good adhesion of the metal layer to the plastic core. Undesirable failure modes that demonstrate poor adhesion of the metal layer to the plastic core include delamination of the metal layer and the plastic core and cracking of the metal layer separate from the plastic core at first, then cracking of the plastic core followed by cracking of the metal layer. It was surprisingly found that the ideal failure mode occurred when the metalized three-dimensional article has a plastic core formed from a liquid radiation curable resin that comprises surface treated glass bubbles. This observation indicates that better adhesion of the metal surface to the plastic core can be achieved when the metalized three-dimensional article has a plastic core formed from a liquid radiation curable resin that comprises surface treated glass bubbles as opposed to a liquid radiation curable resin that comprises other types of inorganic filler, such as dense silica filler or glass fibers.

Because of the better adhesion to the metal shell when using a plastic core formed from a liquid radiation curable resin comprising surface treated glass bubbles, it is possible to create a metal shell that is thinner than what is possible when plating plastic cores made of other components. For instance, very thin metal shells are preferred in applications where the purpose of the metal shell is as a chemical barrier, EMI shield, or decorative coating. When the plastic core comprises surface treated glass bubbles, the formed thin metal shell may be more durable than when the plastic core comprises other inorganic fillers.

In accordance with an embodiment of the invention, the liquid radiation curable resin comprises surface treated glass bubbles, a free radical polymerizable component, and a photoinitiating system capable of initiating free radical polymerization. In another embodiment, the liquid radiation curable resin comprises surface treated glass bubbles, a cationic polymerizable component, and a photoinitiating system capable of initiating cationic polymerization. In a further embodiment, the liquid radiation curable resin comprises surface treated glass bubbles, a free radical polymerizable component, a photoinitiating system capable of initiating free radical polymerization, a cationic polymerizable component, and a photoinitiating system capable of initiating cationic polymerization.

In accordance with an embodiment of the invention, the liquid radiation curable resin of the invention may comprise at least one free-radical polymerizable component, that is, a component which undergoes polymerization initiated by free radicals. The free-radical polymerizable components are monomers, oligomers, and/or polymers; they are monofunctional or polyfunctional materials, i.e., have 1, 2, 3, 4, 5, 6, 7, 8, 9, 10, 20, 30, 40, 50, 100, or more functional groups that can polymerize by free radical initiation, may contain aliphatic, aromatic, cycloaliphatic, arylaliphatic, heterocyclic moiety(ies), or any combination thereof. Examples of polyfunctional materials include dendritic polymers such as dendrimers, linear dendritic polymers, dendrigraft polymers, hyperbranched polymers, star branched polymers, and hypergraft polymers; see US 2009/0093564 A1. The dendritic polymers may contain one type of polymerizable functional group or different types of polymerizable functional groups, for example, acrylates and methacrylate functions.

Examples of free-radical polymerizable components include acrylates and methacrylates such as isobornyl (meth)acrylate, bornyl (meth)acrylate, tricyclodecanyl (meth)acrylate, dicyclopentanyl (meth)acrylate, dicyclopentenyl (meth)acrylate, cyclohexyl (meth)acrylate, benzyl (meth)acrylate, 4-butylcyclohexyl (meth)acrylate, acryloyl morpholine, (meth)acrylic acid, 2-hydroxyethyl (meth)acrylate, 2-hydroxypropyl (meth)acrylate, 2-hydroxybutyl (meth)acrylate, methyl (meth)acrylate, ethyl (meth)acrylate, propyl (meth)acrylate, isopropyl (meth)acrylate, butyl (meth)acrylate, amyl (meth)acrylate, isobutyl (meth)acrylate, t-butyl (meth)acrylate, pentyl (meth)acrylate, caprolactone acrylate, isoamyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, decyl (meth)acrylate, isodecyl (meth)acrylate, tridecyl (meth)acrylate, undecyl (meth)acrylate, lauryl (meth)acrylate, stearyl (meth)acrylate, isostearyl (meth)acrylate, tetrahydrofurfuryl (meth)acrylate, butoxyethyl (meth)acrylate, ethoxydiethylene glycol (meth)acrylate, benzyl (meth)acrylate, phenoxyethyl (meth)acrylate, polyethylene glycol mono(meth)acrylate, polypropylene glycol mono(meth)acrylate, methoxyethylene glycol (meth)acrylate, ethoxyethyl (meth)acrylate, methoxypolyethylene glycol (meth)acrylate, methoxypolypropylene glycol (meth)acrylate, diacetone (meth)acrylamide, beta-carboxyethyl (meth)acrylate, phthalic acid (meth)acrylate, dimethylaminoethyl (meth)acrylate, diethylaminoethyl (meth)acrylate, butylcarbamylethyl (meth)acrylate, n-isopropyl (meth)acrylamide fluorinated (meth)acrylate, 7-amino-3,7-dimethyloctyl (meth)acrylate.

Examples of polyfunctional free-radical polymerizable components include those with (meth)acryloyl groups such as trimethylolpropane tri(meth)acrylate, pentaerythritol (meth)acrylate, ethylene glycol di(meth)acrylate, bisphenol A diglycidyl ether di(meth)acrylate, dicyclopentadiene dimethanol di(meth)acrylate, [2-[1,1-dimethyl-2-[(1-oxoallyl)oxy]ethyl]-5-ethyl-1,3-dioxan-5-yl]methyl acrylate; 3,9-bis(1,1-dimethyl-2-hydroxyethyl)-2,4,8,10-tetraoxaspiro[5.5]undecane di(meth)acrylate; dipentaerythritol monohydroxypenta(meth)acrylate, propoxylated trimethylolpropane tri(meth)acrylate, propoxylated neopentyl glycol di(meth)acrylate, tetraethylene glycol di(meth)acrylate, polyethylene glycol di(meth)acrylate, 1,4-butanediol di(meth)acrylate, 1,6-hexanediol di(meth)acrylate, neopentyl glycol di(meth)acrylate, polybutanediol di(meth)acrylate, tripropyleneglycol di(meth)acrylate, glycerol tri(meth)acrylate, phosphoric acid mono- and di(meth)acrylates, C₇-C₂₀ alkyl di(meth)acrylates, tris(2-hydroxyethyl)isocyanurate tri(meth)acrylate, tris(2-hydroxyethyl)isocyanurate di(meth)acrylate, pentaerythritol tri(meth)acrylate, pentaerythritol tetra(meth)acrylate, dipentaerythritol hexa(meth)crylate, tricyclodecane diyl dimethyl di(meth)acrylate and alkoxylated versions (e.g., ethoxylated and/or propoxylated) of any of the preceding monomers, and also di(meth)acrylate of a diol which is an ethylene oxide or propylene oxide adduct to bisphenol A, di(meth)acrylate of a diol which is an ethylene oxide or propylene oxide adduct to hydrogenated bisphenol A, epoxy (meth)acrylate which is a (meth)acrylate adduct to bisphenol A of diglycidyl ether, diacrylate of polyoxyalkylated bisphenol A, and triethylene glycol divinyl ether, and adducts of hydroxyethyl acrylate.

In accordance with an embodiment, the polyfunctional (meth)acrylates of the polyfunctional component may include all methacryloyl groups, all acryloyl groups, or any combination of methacryloyl and acryloyl groups. In an embodiment, the free-radical polymerizable component is selected from the group consisting of bisphenol A diglycidyl ether di(meth)acrylate, ethoxylated or propoxylated bisphenol A or bisphenol F di(meth)acrylate, dicyclopentadiene dimethanol di(meth)acrylate, [2-[1,1-dimethyl-2-[(1-oxoallyl)oxy]ethyl]-5-ethyl-1,3-dioxan-5-yl]methyl acrylate, dipentaerythritol monohydroxypenta(meth)acrylate, dipentaerythritol hexa(meth)crylate, propoxylated trimethylolpropane tri(meth)acrylate, and propoxylated neopentyl glycol di(meth)acrylate, and any combination thereof.

In another embodiment, the free-radical polymerizable component is selected from the group consisting of bisphenol A diglycidyl ether diacrylate, dicyclopentadiene dimethanol diacrylate, [2-[1,1-dimethyl-2-[(1-oxoallyl)oxy]ethyl]-5-ethyl-1,3-dioxan-5-yl]methyl acrylate, dipentaerythritol monohydroxypentaacrylate, propoxylated trimethylolpropane triacrylate, and propoxylated neopentyl glycol diacrylate, and any combination thereof.

In specific embodiments, the liquid radiation curable resin compositions of the invention include one or more of bisphenol A diglycidyl ether di(meth)acrylate, dicyclopentadiene dimethanol di(meth)acrylate, dipentaerythritol monohydroxypenta(meth)acrylate, propoxylated trimethylolpropane tri(meth)acrylate, and/or propoxylated neopentyl glycol di(meth)acrylate, and more specifically one or more of bisphenol A diglycidyl ether diacrylate, dicyclopentadiene dimethanol diacrylate, dipentaerythritol monohydroxypentaacrylate, propoxylated trimethylolpropane triacrylate, and/or propoxylated neopentyl glycol diacrylate.

The liquid radiation curable resin composition can include any suitable amount of the free-radical polymerizable component, for example, in certain embodiments, in an amount up to about 30 % by weight of the composition, in certain embodiments, and in further embodiments from about 5 % to about 25 % by weight of the composition. In still further embodiments, the amount of free radical polymerizable components comprise from about 10 wt % to about 20 wt % of the total composition.

In all embodiments, the liquid radiation curable resin composition of the present invention includes a photoinitiating system. The photoinitiating system can be a free-radical photoinitiator or a cationic photoinitiator or a photoinitiator that contains both free-radical initiating function and cationic initiating functions on the same molecule. The photoinitiator is a compound that chemically changes due to the action of light or the synergy between the action of light and the electronic excitation of a sensitizing dye to produce at least one of a radical, an acid, and a base.

Typically, free radical photoinitiators are divided into those that form radicals by cleavage, known as "Norrish Type I" and those that form radicals by hydrogen abstraction, known as "Norrish type II". The Norrish type II photoinitiators require a hydrogen donor, which serves as the free radical source. As the initiation is based on a bimolecular reaction, the Norrish type II photoinitiators are generally slower than Norrish type I photoinitiators which are based on the unimolecular formation of radicals. On the other hand, Norrish type II photoinitiators possess better optical absorption properties in the near-UV spectroscopic region. Photolysis of aromatic ketones, such as benzophenone, thioxanthones, benzil, and quinones, in the presence of hydrogen donors, such as alcohols, amines, or thiols leads to the formation of a radical produced from the carbonyl compound (ketyl-type radical) and another radical derived from the hydrogen donor. The photopolymerization of vinyl monomers is usually initiated by the radicals produced from the hydrogen donor. The ketyl radicals are usually not reactive toward vinyl monomers because of the steric hindrance and the delocalization of an unpaired electron.

To successfully formulate a liquid radiation curable resin composition, it is necessary to review the wavelength sensitivity of the photoinitiator(s) present in the composition to determine if they will be activated by the method and wavelength of irradiation chosen to cure the composition.

In accordance with an embodiment, the liquid radiation curable resin composition includes at least one free radical photoinitiator, e.g., those selected from the group consisting of benzoylphosphine oxides, aryl ketones, benzophenones, hydroxylated ketones, 1-hydroxyphenyl ketones, ketals, metallocenes, and any combination thereof.

In an embodiment, the liquid radiation curable resin composition includes at least one free-radical photoinitiator selected from the group consisting of 2,4,6-trimethylbenzoyl diphenylphosphine oxide and 2,4,6-trimethylbenzoyl phenyl, ethoxy phosphine oxide, bis(2,4,6-trimethylbenzoyl)-phenylphosphineoxide, 2-methyl-1- [4-(methylthio)phenyl] -2-morpholinopropanone-1, 2-benzyl-2-(dimethylamino)-1-[4-(4-morpholinyl) phenyl]-1-butanone, 2-dimethylamino-2-(4-methyl-benzyl)-1-(4-morpholin-4-yl-phenyl)-butan-1-one, 4-benzoyl-4'-methyl diphenyl sulphide, 4,4'- bis(diethylamino) benzophenone, and 4,4'-bis(N,N'-dimethylamino) benzophenone (Michler's ketone), benzophenone, 4-methyl benzophenone, 2,4,6-trimethyl benzophenone, dimethoxybenzophenone, 1-hydroxycyclohexyl phenyl ketone, phenyl (1-hydroxyisopropyl)ketone, 2-hydroxy-1-4-(2-hydroxyethoxy) phenyl]-2-methyl-1-propanone, 4-isopropylphenyl(1-hydroxyisopropyl)ketone, oligo-[2-hydroxy--2-methyl-1-[4-(1-methylvinyl)phenyl] propanone], camphorquinone, 4,4'-bis(diethylamino) benzophenone, benzil dimethyl ketal, bis(eta 5-2-4-cyclopentadien-1-yl) bis[2,6-difluoro-3-(1H-pyrrol-1-yl) phenyl] titanium, and any combination thereof.

For light sources emitting in the 300-475 nm wavelength range, especially those emitting at 365 nm, 390 nm, or 395 nm, examples of suitable free-radical photoinitiators absorbing in this area include: benzoylphosphine oxides, such as, for example, 2,4,6-trimethylbenzoyl diphenylphosphine oxide (Lucirin TPO from BASF) and 2,4,6-trimethylbenzoyl phenyl, ethoxy phosphine oxide (Lucirin TPO-L from BASF), bis(2,4,6-trimethylbenzoyl)-phenylphosphineoxide (Irgacure 819 or BAPO from Ciba), 2-methyl-1-[4-(methylthio)phenyl]-2-morpholinopropanone-1 (Irgacure 907 from Ciba), 2-benzyl-2-(dimethylamino)-1-[4-(4-morpholinyl) phenyl]-1-butanone (Irgacure 369 from Ciba), 2-dimethylamino-2-(4-methyl-benzyl)-1-(4-morpholin-4-yl-phenyl)-butan-1-one (Irgacure 379 from Ciba), 4-benzoyl-4'-methyl diphenyl sulphide (Chivacure BMS from Chitec), 4,4'-bis(diethylamino) benzophenone (Chivacure EMK from Chitec), and 4,4'-bis(N,N'-dimethylamino) benzophenone (Michler's ketone). Also suitable are mixtures thereof.

Additionally, photosensitizers are useful in conjunction with photoinitiators in effecting cure with light sources emitting in this wavelength range. Examples of suitable photosensitizers include: anthraquinones, such as 2- methylanthraquinone, 2-ethylanthraquinone, 2-tertbutylanthraquinone, 1-chloroanthraquinone, and 2-amylanthraquinone, thioxanthones and xanthones, such as isopropyl thioxanthone, 2-chlorothioxanthone, 2,4-diethylthioxanthone, and 1-chloro-4-propoxythioxanthone, methyl benzoyl formate (Darocur MBF from Ciba), methyl-2-benzoyl benzoate (Chivacure OMB from Chitec), 4-benzoyl-4'-methyl diphenyl sulphide (Chivacure BMS from Chitec), 4,4'- bis(diethylamino) benzophenone (Chivacure EMK from Chitec).

It is possible for UV light sources to be designed to emit light at shorter wavelengths. For light sources emitting at wavelengths from between about 100 and about 300 nm, it is desirable to employ a photosensitizer with a photoinitiator. When photosensitizers, such as those previously listed are present in the formulation, other photoinitiators absorbing at shorter wavelengths can be used. Examples of such photoinitiators include: benzophenones, such as benzophenone, 4-methyl benzophenone, 2,4,6-trimethyl benzophenone, and dimethoxybenzophenone, and, 1-hydroxyphenyl ketones, such as 1-hydroxycyclohexyl phenyl ketone, phenyl (1-hydroxyisopropyl)ketone, 2-hydroxy-1-[4-(2-hroxyethoxy) phenyl]-2-methyl-1-propanone, and 4-isopropylphenyl(1-hydroxyisopropyl)ketone, benzil dimethyl ketal, and oligo-[2-hydroxy-2-methyl-1-[4-(1-methylvinyl)phenyl] propanone] (Esacure KIP 150 from Lamberti).

Light sources can also be designed to emit visible light. For light sources emitting light at wavelengths from about 475 nm to about 900nm, examples of suitable free radical photoinitiators include: camphorquinone, 4,4'-bis(diethylamino) benzophenone (Chivacure EMK from Chitec), 4,4'-bis(N,N'-dimethylamino) benzophenone (Michler's ketone), bis(2,4,6-trimethylbenzoyl)-phenylphosphineoxide (Irgacure 819 or BAPO from Ciba), metallocenes such as bis (eta 5-2-4-cyclopentadien-1-yl) bis [2,6-difluoro-3-(1H-pyrrol-1-yl) phenyl] titanium (Irgacure 784 from Ciba), and the visible light photoinitiators from Spectra Group Limited, Inc. such as H-Nu 470, H-Nu-535, H-Nu-635, H-Nu-Blue-640, and H-Nu-Blue-660.

The liquid radiation curable resin composition can include any suitable amount of the free-radical photoinitiator, for example, in certain embodiments, in an amount up to about 8 % by weight of the composition, in certain embodiments, up to about 6 % by weight of the composition, and in further embodiments from about 0.2 % to about 5 % by weight of the composition. In other embodiments, the amount of free-radical photoinitiator is present in an amount of from about 1 wt% to about 4 wt% of the total composition, more preferably from about 1 wt% to about 3 wt% of the total composition.

In accordance with an embodiment, liquid radiation curable resin compositions of the invention comprise at least one cationically polymerizable component, that is, a component which undergoes polymerization initiated by cations or in the presence of acid generators. The cationically polymerizable components may be monomers, oligomers, and/or polymers, and may contain aliphatic, aromatic, cycloaliphatic, arylaliphatic, heterocyclic moiety(ies), and any combination thereof. Suitable cyclic ether compounds can comprise cyclic ether groups as side groups or groups that form part of an alicyclic or heterocyclic ring system.

The cationic polymerizable component is selected from the group consisting of cyclic ether compounds, cyclic acetal compounds, cyclic thioethers compounds, spiro-orthoester compounds, cyclic lactone compounds, and vinyl ether compounds, and any combination thereof.

Examples of cationically polymerizable components include cyclic ether compounds such as epoxy compounds and oxetanes, cyclic lactone compounds, cyclic acetal compounds, cyclic thioether compounds, spiro orthoester compounds, and vinylether compounds. Specific examples of cationically polymerizable components include bisphenol A diglycidyl ether, bisphenol F diglycidyl ether, bisphenol S diglycidyl ether, brominated bisphenol A diglycidyl ether, brominated bisphenol F diglycidyl ether, brominated bisphenol S diglycidyl ether, epoxy novolac resins, hydrogenated bisphenol A diglycidyl ether, hydrogenated bisphenol F diglycidyl ether, hydrogenated bisphenol S diglycidyl ether, 3,4-epoxycyclohexylmethyl-3',4'-epoxycyclohexanecarboxylate, 2-(3,4-epoxycyclohexyl-5,5-spiro-3,4-epoxy)-cyclohexane-1,4-dioxane, bis(3,4-epoxycyclohexylmethyl)adipate, vinylcyclohexene oxide, 4-vinylepoxycyclohexane, vinylcyclohexene dioxide, limonene oxide, limonene dioxide, bis(3,4-epoxy-6-methylcyclohexylmethyl)adipate, 3,4-epoxy-6-methylcyclohexyl-3',4'-epoxy-6'-methylcyclohexanecarboxylate, e-caprolactone-modified 3,4-epoxycyclohexylmethyl-3',4'-epoxycyclohexane carboxylates, trimethylcaprolactone-modified 3,4-epoxycyclohexylmethyl-3',4'-epoxycyclohexane carboxylates, β-methyl-δ-valerolactone-modified 3,4-epoxycyclohexcylmethyl-3',4'-epoxycyclohexane carboxylates, methylenebis(3,4-epoxycyclohexane), bicyclohexyl-3,3'-epoxide, bis(3,4-epoxycyclohexyl) with a linkage of -O-, -S-, -SO-, -SO₂-, -C(CH₃)₂-, -CBr₂-, -C(CBr₃)₂-, -C(CF₃)₂-, -C(CCl₃)₂-, or -CH(C₆H₅)-, dicyclopentadiene diepoxide, di(3,4-epoxycyclohexylmethyl) ether of ethylene glycol, ethylenebis (3,4- epoxycyclohexanecarboxylate), epoxyhexahydrodioctylphthalate, epoxyhexahydro-di-2-ethylhexyl phthalate, 1,4-butanediol diglycidyl ether, 1,6-hexanediol diglycidyl ether, neopentylglycol diglycidyl ether, glycerol triglycidyl ether, trimethylolpropane triglycidyl ether, polyethylene glycol diglycidyl ether, polypropylene glycol diglycidyl ether, polyglycidyl ethers of polyether polyol obtained by the addition of one or more alkylene oxides to aliphatic polyhydric alcohols such as ethylene glycol, propylene glycol, and glycerol, diglycidyl esters of aliphatic long-chain dibasic acids, monoglycidyl ethers of aliphatic higher alcohols, monoglycidyl ethers of phenol, cresol, butyl phenol, or polyether alcohols obtained by the addition of alkylene oxide to these compounds, glycidyl esters of higher fatty acids, epoxidated soybean oil, epoxybutylstearic acid, epoxyoctylstearic acid, epoxidated linseed oil, epoxidated polybutadiene, 1,4-bis[(3-ethyl-3-oxetanylmethoxy)methyl]benzene, 3-ethyl-3-hydroxymethyloxetane, 3-ethyl-3-(3-hydroxypropyl)oxymethyloxetane, 3-ethyl-3-(4- hydroxybutyl)oxymethyloxetane, 3-ethyl-3-(5-hydroxypentyl)oxymethyloxetane, 3-ethyl-3-phenoxymethyloxetane, bis((1-ethyl(3-oxetanyl))methyl)ether, 3-ethyl-3-((2-ethylhexyloxy)methyl)oxetane, 3-ethyl-((triethoxysilylpropoxymethyl)oxetane, 3-(meth)-allyloxymethyl-3-ethyloxetane, (3-ethyl-3-oxetanylmethoxy)methylbenzene, 4-fluoro-[1-(3-ethyl-3-oxetanylmethoxy)methyl]benzene, 4-methoxy-[1-(3-ethyl-3-oxetanylmethoxy)methyl]-benzene, [1-(3-ethyl-3-oxetanylmethoxy)ethyl]phenyl ether, isobutoxymethyl(3-ethyl-3-oxetanylmethyl)ether, 2-ethylhexyl(3-ethyl-3-oxetanylmethyl)ether, ethyldiethylene glycol(3-ethyl-3-oxetanylmethyl)ether, dicyclopentadiene (3-ethyl-3-oxetanylmethyl)ether, dicyclopentenyloxyethyl(3-ethyl-3-oxetanylmethyl)ether, dicyclopentenyl(3-ethyl-3-oxetanylmethyl)ether, tetrahydrofurfuyl(3-ethyl-3-oxetanylmethyl)ether, 2-hydroxyethyl(3-ethyl-3-oxetanylmethyl)ether, 2-hydroxypropyl(3-ethyl-3-oxetanylmethyl)ether, and any combination thereof. Examples of polyfunctional materials that are cationically polymerizable include dendritic polymers such as dendrimers, linear dendritic polymers, dendrigraft polymers, hyperbranched polymers, star branched polymers, and hypergraft polymers with epoxy or oxetane functional groups. The dendritic polymers may contain one type of polymerizable functional group or different types of polymerizable functional groups, for example, epoxy and oxetane functions.

In embodiments of the invention, the cationic polymerizable component is at least one selected from the group consisting of a cycloaliphatic epoxy and an oxetane. In a specific embodiment, the cationic polymerizable component is an oxetane, for example, an oxetane containing 2 or more than 2 oxetane groups. In another specific embodiment, the cationic polymerizable component is a cycloaliphatic epoxy, for example, a cycloaliphatic epoxy with 2 or more than 2 epoxy groups.

In an embodiment, the epoxide is 3,4-epoxycyclohexylmethyl-3',4'-epoxycyclohexanecarboxylate (available as CELLOXIDETM 2021P from Daicel Chemical, or as CYRACURETM UVR-6105 from Dow Chemical), hydrogenated bisphenol A-epichlorohydrin based epoxy resin (available as EPONEXTM 1510 from Hexion), 1,4-cyclohexanedimethanol diglycidyl ether (available as HELOXYTM 107 from Hexion), neopentylglycol diglycidylether (available as HELOXYTM 68 from Hexion), a mixture of dicyclohexyl diepoxide and nanosilica (available as NANOPOXTM), and any combination thereof.

The above-mentioned cationically polymerizable compounds can be used singly or in combination of two or more thereof.

The liquid radiation curable resin composition can include any suitable amount of the cationic polymerizable component, for example, in certain embodiments, in an amount up to about 75 % by weight of the composition, and in further embodiments from about 5 % to about 75 % by weight of the composition. In other embodiments the amount of cationically polymerizable components if from about 10 wt% to about 70 wt% of the total composition, in other embodiments from 20 wt% to about 70 wt%, and in further embodiments form about 30 wt% to about 60 wt% of the composition.

In accordance with an embodiment, the polymerizable component of the liquid radiation curable resin composition is polymerizable by both free-radical polymerization and cationic polymerization. An example of such a polymerizable component is a vinyloxy compound, for example, one selected from the group consisting of bis(4-vinyloxybutyl)isophthalate, tris(4-vinyloxybutyl) trimellitate, and combinations thereof.

In accordance with an embodiment, the liquid radiation curable resin composition includes a photoinitiating system that is a photoinitiator having both cationic initiating function and free radical initiating function. In accordance with an embodiment, the liquid radiation curable resin composition includes a cationic photoinitiator. The cationic photoinitiator generates photoacids upon irradiation of light. They generate Brönsted or Lewis acids upon irradiation.

In an embodiment, any suitable cationic photoinitiator can be used, for example, those selected from the group consisting of onium salts, halonium salts, iodosyl salts, selenium salts, sulfonium salts, sulfoxonium salts, diazonium salts, metallocene salts, isoquinolinium salts, phosphonium salts, arsonium salts, tropylium salts, dialkylphenacylsulfonium salts, thiopyrilium salts, diaryl iodonium salts, triaryl sulfonium salts, sulfonium antimonate salts, ferrocenes, di(cyclopentadienyliron)arene salt compounds, cyclohexeneoxide compounds, and pyridinium salts, and any combination thereof. Onium salts, e.g., iodonium salts, sulfonium salts and ferrocenes, have the advantage that they are thermally stable. Thus, any residual photoinitiator does not continue to cure after the removal of the irradiating light. Cationic photoinitiators offer the advantage that they are not sensitive to oxygen present in the atmosphere.

The liquid radiation curable resin composition of the invention includes at least one cationic photoinitiator, wherein the cationic photoinitiator is selected from the group consisting of aromatic diazonium salts, aromatic sulfonium salts, aromatic iodonium salts, metallocene based compounds, aromatic phosphonium salts and silanol aluminium complexes, and any combination thereof. In an embodiment, the cationic photoinitiator is selected from the group consisting of aromatic sulfonium salts, aromatic iodonium salts, and metallocene based compounds, and any combination thereof. In another embodiment, the cationic photoinitiator is selected from the group consisting of triarylsulfonium salts, diaryliodonium salts, and metallocene based compounds, and any combination thereof.

In a particular embodiment, the cationic photoinitiator has an anion selected from the group consisting of BF₄⁻, AsF₆⁻, SbF₆⁻, PF₆⁻, B(C₆F₅)₄⁻, Ga(C₆F₅)₄⁻, [(C₆F₅)₃B-C₃H₃N₂-B(C₆F₅)₃]⁻, tetrakis(3,5-difluoro-4-methoxyphenyl)borate, perfluoroalkylsulfonates, perfluoroalkylphosphates, and carborane anions.

In an embodiment, the cationic photoinitiator has a cation selected from the group consisting of aromatic sulfonium salts, aromatic iodonium salts, and metallocene based compounds with at least an anion selected from the group consisting of SbF₆⁻, PF₆⁻, B(C₆F₅)₄⁻, Ga(C₆F₅)₄⁻, [(C₆F₅)₃B-C₃H₃N₂-B(C₆F₅)₃]⁻, tetrakis(3,5-difluoro-4-methoxyphenyl)borate, perfluoroalkylsulfonates, perfluoroalkylphosphates, and (CH₆B₁₁Cl₆)⁻.

In a particular embodiment, the cationic photoinitiator is an aromatic sulfonium salt based cationic photoinitiator selected from the group consisting of 4-(4-benzoylphenylthio)phenyldiphenylsulfonium hexafluoroantimonate, 4-(4-benzoylphenylthio)phenylbis(4-hydroxyethyloxyphenyl)sulfonium hexafluoroantimonate, 4-(4-benzoylphenylthio)phenylbis(4-fluorophenyl)sulfonium hexafluoroantimonate, 4-(4-benzoylphenylthio)phenylbis(4-chlorophenyl)sulfonium hexafluoroantimonate, 4-[4-(3-chlorobenzoyl)phenylthio]phenylbis (4-fluorophenyl)sulfonium hexafluoroantimonate, 4-(4-benzoylphenylthio)phenylbis (4-methylphenyl)sulfonium hexafluoroantimonate, 4-(4-benzoylphenylthio)phenylbis(4-hydroxyethylphenyl)sulfonium hexafluoroantimonate, 4-[4-(4-hydroxyethyloxybenzoyl)phenylthio]phenylbis(4-fluoro phenyl)sulfonium hexafluoroantimonate, 4-[4-(4-hydroxyethyloxybenzoyl)phenylthio]phenyldiphenylsulfonium hexafluoroantimonate, 4-[4-(4-hydroxyethyloxybenzoyl)phenylthio]phenyl bis(4-hydroxyethyloxyphenyl)sulfonium hexafluoroantimonate, 4-(4-benzoylphenylthio)phenyl bis(4-methoxyethoxyphenyl)sulfonium hexafluoroantimonate, 4-[4-(3-methoxybenzoyl)phenylthio]phenyldiphenylsulfonium hexafluoroantimonate, 4-[4-(3-methoxycarbonylbenzoyl)phenylthio]phenyldiphenylsulfonium hexafluoroantimonate, 4- [4-(2-hydroxymethylbenzoyl)phenylthio]phenyldiphenylsulfonium hexafluoroantimonate, 4-[4-(4-methylbenzoyl)phenylthio]phenyl bis(4-fluorophenyl)sulfonium hexafluoroantimonate, 4-[4-(4-)phenylthio]phenyl bis(4-fluorophenyl)sulfonium hexafluoroantimonate, 4-[4-(4-fluorobenzoyl)phenylthio]phenyl bis(4-fluorophenyl)sulfonium hexafluoroantimonate, 4-[4-(2-methoxycarbonylbenzoyl)phenylthio]phenyl bis(4-fluoro phenyl)sulfonium hexafluoroantimonate, bis[4-(diphenylsulfonio)phenyl]sulfide bishexafluorophosphate, bis[4-(diphenylsulfonio)phenyl] sulfide bistetrafluoroborate, bis[4-(diphenylsulfonio)phenyl]sulfide tetrakis(pentafluorophenyl)borate, diphenyl-4-(phenylthio)phenylsulfonium hexafluorophosphate, diphenyl-4-(phenylthio)phenylsulfonium tetrafluoroborate, diphenyl-4-(phenylthio)phenylsulfonium tetrakis(pentafluorophenyl)borate, triphenylsulfonium hexafluorophosphate, triphenylsulfonium hexafluoroantimonate, triphenylsulfonium tetrafluoroborate, triphenylsulfonium tetrakis(pentafluorophenyl)borate, bis[4-(di(4-(2-hydroxyethoxy))phenylsulfonio)phenyl] sulfide bishexafluorophosphate, bis[4-(di(4-(2-hydroxyethoxy))phenylsulfonio)phenyl]sulfide bistetrafluoroborate, and bis[4-(di(4-(2-hydroxyethoxy))phenylsulfonio)phenyl] sulfide tetrakis(pentafluorophenyl)borate, and any combination thereof.

In another embodiment, the cationic photoinitiator is an aromatic iodonium salt based cationic photoinitiator selected from the group consisting of diphenyliodonium hexafluorophosphate, diphenyliodonium hexafluoroantimonate, diphenyliodonium tetrafluoroborate, diphenyliodonium tetrakis(pentafluorophenyl)borate, bis(dodecylphenyl)iodonium hexafluorophosphate, bis(dodecylphenyl)iodonium hexafluoroantimonate, bis(dodecylphenyl)iodonium tetrafluoroborate, bis(dodecylphenyl)iodonium tetrakis(pentafluorophenyl)borate, 4-methylphenyl-4-(1-methylethyl)phenyliodonium hexafluorophosphate, 4-methylphenyl-4-(1-methylethyl)phenyliodonium hexafluoroantimonate, 4-methylphenyl-4-(1-methylethyl)phenyliodonium tetrafluoroborate, and 4-methylphenyl-4-(1-methylethyl)phenyliodonium tetrakis(pentafluorophenyl)borate, and any combination thereof.

In certain embodiments, the cationic photoinitiator is selected from the group consisting of tetrakis(pentafluorophenyl)borate or hexafluoroantimonate salt of 4-(4-benzoylphenylthio)phenyldiphenylsulfonium, 4-(4-benzoylphenylthio)phenylbis(4-hydroxyethyloxyphenyl)sulfonium, 4-(4-benzoylphenylthio)phenylbis(4-fluorophenyl)sulfonium, 4-(4-benzoylphenylthio)phenylbis(4-chlorophenyl)sulfonium, 4- [4-(3-chlorobenzoyl)phenylthio] phenylbis(4-fluorophenyl)sulfonium, 4-[4-(2-chlorobenzoyl)phenylthio]phenylbis(4-fluorophenyl)sulfonium, (4-thiophenoxyphenyl)diphenylsulfonium, S,S,S',S'-tetraphenylthiobis(4,1-phenylene)disulfonium, triphenylsulfonium, (chlorophenyl)diphenylsulfonium, chloro[S-(phenyl)thianthrenium], S-(phenyl)thianthrenium, diphenyl-4-(4'-thiophenoxy)thiophenoxyphenylsulfonium, phenyldi(4-thiophenoxyphenyl)sulfonium, S-(4-thiophenoxyphenyl)thianthrenium, and (thiodi-4,1-phenylene)bis[bis[4-(2-hydroxyethoxy)phenyl]sulfonium, tris(4-(4-acetylphenyl)thiophenyl)sulfonium, bis(4-dodecylphenyl)iodonium, [4-[(2-hydroxytetradecyl)oxy]phenyl]phenyliodonium, (4-methylphenyl) [4-[[2-[[[[3-(trifluoromethyl)phenyl]amino]carbonyl]oxy]tetradecyl]oxy]phenyl] iodonium, bis(4-dodecylphenyl)iodonium, [4-(1-methylethyl)phenyl] (4-methylphenyl)iodonium, and any combination thereof.

In an illustrative embodiment, the liquid radiation curable resin composition includes a cationic photoinitiator selected from the group consisting of triarylsulfonium SbF₆⁻, triarylsulfonium borate, tris(4-(4-acetylphenyl)thiophenyl)sulfonium tetrakis(pentafluorophenyl)borate, diaryliodonium borate, iodonium [4-(1-methylethyl)phenyl](4-methylphenyl)-tetrakis(pentafluorophenyl)borate, and any combination thereof. A nonnucleophilic anion serves as the counterion. Examples of such anions include BF₄⁻, AsF₆⁻, SbF₆⁻, PF₆⁻, B(C₆F₅)₄⁻, perfluoroalkylsulfonates, perfluoroalkylphosphates, and carborane anions such as (CH₆B₁₁Cl₆)⁻.

Examples of cationic photoinitiators useful for curing at 300-475 nm, particularly at 365 nm UV light, without a sensitizer include 4-[4-(3-chlorobenzoyl)phenylthio]phenylbis(4-fluorophenyl)sulfonium hexafluoroantimonate, 4-[4-(3-chlorobenzoyl)phenylthio]phenyl bis(4-fluorophenyl)sulfonium tetrakis(pentafluorophenyl)borate, and tris(4-(4-acetylphenyl)thiophenyl)sulfonium tetrakis(pentafluorophenyl)borate.

In some embodiments it is desirable for the liquid radiation curable resin composition to include a photosensitizer. The term "photosensitizer" is used to refer to any substance that either increases the rate of photoinitiated polymerization or shifts the wavelength at which polymerization occurs; see textbook by G. Odian, Principles of Polymerization, 3^{rd} Ed., 1991, page 222. Examples of photosensitizers include those selected from the group consisting of methanones, xanthenones, pyrenemethanols, anthracenes, pyrene, perylene, quinones, xanthones, thioxanthones, benzoyl esters, benzophenones, and any combination thereof. Particular examples of photosensitizers include those selected from the group consisting of [4-[(4-methylphenyl)thio]phenyl]phenyl-methanone, isopropyl-9H-thioxanthen-9-one, 1-pyrenemethanol, 9-(hydroxymethyl)anthracene, 9,10-diethoxyanthracene, 9,10-dimethoxyanthracene, 9,10-dipropoxyanthracene, 9,10-dibutyloxyanthracene, 9-anthracenemethanol acetate, 2-ethyl-9,10-dimethoxyanthracene, 2-methyl-9,10-dimethoxyanthracene, 2-t-butyl-9,10-dimethoxyanthracene, 2-ethyl-9,10-diethoxyanthracene and 2-methyl-9,10-diethoxyanthracene, anthracene, anthraquinones, 2- methylanthraquinone, 2-ethylanthraquinone, 2-tertbutylanthraquinone, 1-chloroanthraquinone, 2-amylanthraquinone, thioxanthones and xanthones, isopropyl thioxanthone, 2-chlorothioxanthone, 2,4-diethylthioxanthone, 1-chloro-4-propoxythioxanthone, methyl benzoyl formate, methyl-2-benzoyl benzoate, 4-benzoyl-4'-methyl diphenyl sulphide, 4,4'- bis(diethylamino) benzophenone, and any combination thereof.

Additionally, photosensitizers are useful in combination with photoinitiators in effecting cure with light sources emitting in the wavelength range of 300-475 nm. Examples of suitable photosensitizers include: anthraquinones, such as 2-methylanthraquinone, 2-ethylanthraquinone, 2-tertbutylanthraquinone, 1-chloroanthraquinone, and 2-amylanthraquinone, thioxanthones and xanthones, such as isopropyl thioxanthone, 2-chlorothioxanthone, 2,4-diethylthioxanthone, and 1-chloro-4-propoxythioxanthone, methyl benzoyl formate (Darocur MBF from Ciba), methyl-2-benzoyl benzoate (Chivacure OMB from Chitec), 4-benzoyl-4'-methyl diphenyl sulphide (Chivacure BMS from Chitec), 4,4'- bis(diethylamino) benzophenone (Chivacure EMK from Chitec).

In an embodiment, the photosensitizer is a fluorone, e.g., 5,7-diiodo-3-butoxy-6-fluorone, 5,7-diiodo-3-hydroxy-6-fluorone, 9-cyano-5,7-diiodo-3-hydroxy-6-fluorone, or a photosensitizer is 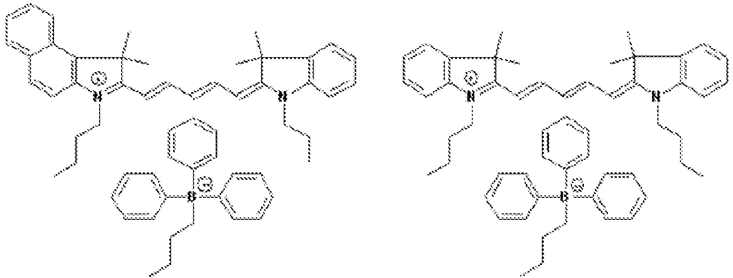 and any combination thereof.

The liquid radiation curable resin composition can include any suitable amount of the photosensitizer, for example, in certain embodiments, in an amount up to about 10 % by weight of the composition, in certain embodiments, up to about 5 % by weight of the composition, and in further embodiments from about 0.05 % to about 2 % by weight of the composition.

When photosensitizers are employed, other photoinitiators absorbing at shorter wavelengths can be used. Examples of such photoinitiators include: benzophenones, such as benzophenone, 4-methyl benzophenone, 2,4,6-trimethyl benzophenone, and dimethoxybenzophenone, and 1-hydroxyphenyl ketones, such as 1-hydroxycyclohexyl phenyl ketone, phenyl (1-hydroxyisopropyl)ketone, 2-hydroxy-1-[4-(2-hydroxyethoxy) phenyl]-2-methyl-1-propanone, and 4-isopropylphenyl(1-hydroxyisopropyl)ketone, benzil dimethyl ketal, and oligo-[2-hydroxy-2-methyl-1-[4-(1-methylvinyl)phenyl] propanone] (Esacure KIP 150 from Lamberti). These photoinitiators when used in combination with a photosensitizer are suitable for use with light sources emitting at wavelengths from about 100 nm to about 300 nm.

Light sources that emit visible light are also known. For light sources emitting light at wavelengths greater than about 400 nm, e.g., from about 475 nm to about 900 nm, examples of suitable photoinitiators include: camphorquinone, 4,4'-bis(diethylamino) benzophenone (Chivacure EMK from Chitec), 4,4'-bis(N,N'-dimethylamino) benzophenone (Michler's ketone), bis(2,4,6-trimethylbenzoyl)-phenylphosphineoxide (Irgacure 819 or BAPO from Ciba), metallocenes such as bis(eta 5-2-4-cyclopentadien-1-yl) bis[2,6-difluoro-3-(1H-pyrrol-1-yl) phenyl] titanium (Irgacure 784 from Ciba), and the visible light photoinitiators from Spectra Group Limited, Inc. such as H-Nu 470, H-Nu-535, H-Nu-635, H-Nu-Blue-640, and H-Nu-Blue-660.

A photosensitizer or co-initiator may be used to improve the activity of the cationic photoinitiator. It is for either increasing the rate of photoinitiated polymerization or shifting the wavelength at which polymerization occurs. The sensitizer used in combination with the above-mentioned cationic photoinitiator is not particularly limited. A variety of compounds can be used as photosensitizers, including heterocyclic and fused-ring aromatic hydrocarbons, organic dyes, and aromatic ketones. Examples of sensitizers include compounds disclosed by J. V. Crivello in Advances in Polymer Science, 62, 1 (1984), and by J. V. Crivello & K. Dietliker, "Photoinitiators for Cationic Polymerization" in Chemistry & technology of UV & EB formulation for coatings, inks & paints. Volume III, Photoinitiators for free radical and cationic polymerization. by K. Dietliker; [Ed. by P.K.T. Oldring], SITA Technology Ltd, London, 1991. Specific examples include polyaromatic hydrocarbons and their derivatives such as anthracene, pyrene, perylene and their derivatives, thioxanthones, α-hydroxyalkylphenones, 4-benzoyl-4'-methyldiphenyl sulfide, acridine orange, and benzoflavin.

There are a large number of known and technically proven cationic photoinitiators that are suitable. They include, for example, onium salts with anions of weak nucleophilicity. Examples are halonium salts, iodosyl salts or sulfonium salts, such as are described in published European patent application EP 153904 and WO 98/28663, sulfoxonium salts, such as described, for example, in published European patent applications EP 35969, 44274, 54509, and 164314, or diazonium salts, such as described, for example, in U.S. Pat. Nos. 3,708,296 and 5,002,856. Other cationic photoinitiators are metallocene salts, such as described, for example, in published European applications EP 94914 and 94915.

A survey of other current onium salt initiators and/or metallocene salts can be found in "UV Curing, Science and Technology", (Editor S. P. Pappas, Technology Marketing Corp., 642 Westover Road, Stamford, Conn., U.S.A.) or "Chemistry & Technology of UV & EB Formulation for Coatings, Inks & Paints", Vol. 3 (edited by P. K. T. Oldring).

Suitable ferrocene type cationic photoinitiators include, for example, di(cyclopentadienyliron)arene salt compounds of formula (I) as disclosed in Chinese Patent No. CN 101190931: 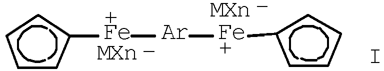 wherein anion MXn- is selected from BF₄, PF₆, SbF₆, AsF₆, (C₆F₅)₄B, ClO₄, CF₃SO₃, FSO₃, CH₃SO₃, C₄F₉SO₃, and Ar is a fused ring or polycyclic arene.

Other illustrative ferrocene type cationic photoinitiators include, for example,(η6-Carbazole)(η5-cyclopenta-dienyl) iron hexafluorophosphate salts, specifically [cyclopentadiene-Fe-N-butylcarbazole] hexafluoro-phosphate (C₄-CFS PF₆) and [cyclopentadiene-Fe-N-octyl-carbazole] hexafluorophosphate (C₈-CFS PF₆), bearing C₄ and C₈ alkyl chains, respectively, on the nitrogen atom (see Polymer Eng. & Science (2009), 49(3), 613-618); ferrocenium dication salts, e.g., biphenyl bis[(π-cyclopentadienyl) iron] hexafluorophosphate ([bis(Cp-Fe)-biphenyl] (PF₆)₂) and straight cyclopentadien-iron-biphenyl hexafluorophosphate ([Cp-Fe-biphenyl]⁺PF₆⁻) as disclosed in Chinese J. Chem. Engnrng (2008), 16(5), 819-822 and Polymer Bulltn (2005), 53(5-6), 323-331; cyclopentadienyl-Fe-carbazole hexafluorophosphate ([Cp-Fe-carbazole]⁺PF₆⁻), cyclopentadienyl-Fe-N-ethylcarbazole hexafluorophosphate ([Cp-Fe-n-ethylcarbazole]⁺PF₆⁻) and cyclopentadienyl-Fe-aminonaphthalene hexafluorophosphate ([Cp-Fe-aminonaphthalene]⁺PF₆⁻) as disclosed in J Photochem. & Photobiology, A: Chemistry (2007), 187(2-3), 389-394 and Polymer Intnl (2005), 54(9), 1251-1255; alkoxy-substituted ferrocenium salts, for example, [cyclopendadien-Fe-anisole]PF₆, [cyclopendadien-Fe-anisole]BF₄, [cyclopendadien-Fe-diphenylether]PF₆, [cyclo-pendadien-Fe-diphenylether]BF₄, and [cyclopendadien-Fe-diethoxy-benzene]PF₆, as disclosed in Chinese J. of Chem Engnrng (2006), 14(6), 806-809; cyclopentadiene-iron-arene tetrafluoroborates, for example, cyclopentadiene-iron-naphthalene tetrafluoroborate ([Cp-Fe-Naph] BF₄) salt, as disclosed in Imaging Science J (2003), 51(4), 247-253; ferrocenyl tetrafluoroborate ([Cp-Fe-CP]BF₄), as disclosed in Ganguang Kexue Yu Guang Huaxue (2003), 21(1), 46-52; [CpFe(η6-tol)]BF₄, as disclosed in Ganguang Kexue Yu Guang Huaxue (2002), 20(3), 177-184, Ferrocenium salts (η6-α-naphthoxybenzene) (η5-cyclopentadienyl) iron hexafluorophosphate (NOFC-1) and (η6-β-naphthoxybenzene) (η5-cyclopentadienyl) iron hexafluorophosphate (NOFC-2), as disclosed in Int. J of Photoenergy (2009), Article ID 981065; (η6-Diphenyl-methane) (η5-cyclopentadienyl) iron hexafluorophosphate and (η6-benzophenone) (η5-cyclopenta-dienyl) iron hexafluorophosphate, as disclosed in Progress in Organic Coatings (2009), 65(2), 251-256; [CpFe(η6-isopropyl-benzene)]PF₆, as disclosed in Chem Comm (1999), (17), 1631-1632; and any combination thereof.

Suitable onium type cationic photoinitiators include, for example, iodonium and sulfonium salts, as disclosed in Japanese Patent JP 2006151852. Other illustrative onium type photoinitiators include, for example, onium salts such as, diaryliodonium salts, triarylsulfonium salts, aryl-diazonium salts, ferrocenium salts, diarylsulfoxonium salts, diaryl-iodoxonium salts, triaryl-sulfoxonium salts, dialkylphenacyl-sulfonium salts, dialkylhydroxy-phenylsulfonium salts, phenacyl-triarylphosphonium salts, and phenacyl salts of heterocyclic nitrogen-containing compounds, as disclosed in U.S. Patent Nos. 5,639,413; 5,705,116; 5,494618; 6,593,388; and Chemistry of Materials (2002), 14(11), 4858-4866; aromatic sulfonium or iodonium salts as disclosed in U.S. Patent Application No. 2008/0292993; diaryl-, triaryl-, or dialkylphenacylsulfonium salts, as disclosed in US2008260960 and J. Poly Sci, Part A (2005), 43(21), 5217; diphenyl-iodonium hexafluorophosphate (Ph₂I⁺PF₆⁻), as disclosed in Macromolecules (2008), 41(10), 3468-3471; onium salts using onium salts using less toxic anions to replace, e.g., SbF₆⁻. Mentioned are anions: B(C₆F₅)₄⁻, Ga(C₆F₅)₄⁻ and perfluoroalkyl fluorophosphate, PFₙRf₍₆₋ₙ₎⁻, as disclosed in Nettowaku Porima (2007), 28(3), 101-108; Photoactive allyl ammonium salt (BPEA) containing benzophenone moiety in the structure, as disclosed in Eur Polymer J (2002), 38(9), 1845-1850; 1-(4-Hydroxy-3-methylphenyl) tetrahydrothiophenium hexafluoroantimonate, as disclosed in Polymer (1997), 38(7), 1719-1723; and any combination thereof.

Illustrative iodonium type cationic photoinitiators include, for example, diaryliodonium salts having counterions like hexafluoro-phosphate and the like, such as, for example, (4-n-pentadecyloxy-phenyl)phenyliodonium hexa-fluoroantimonate, as disclosed in US2006041032; diphenyliodonium hexafluorophosphate, as disclosed in US4394403 and Macromolecules (2008), 41(2), 295-297; diphenyliodonium ions as disclosed in Polymer (1993), 34(2), 426-8; Diphenyliodonium salt with boron tetrafluoride (Ph₂I⁺ BF₄⁻), as disclosed in Yingyong Huaxue (1990), 7(3), 54-56; SR-1012, a diaryldiodonium salt, as disclosed in Nuclear Inst. & Methods in Physics Res, B (2007), 264(2), 318-322; diaryliodonium salts, e.g., 4,4'-di-tert-butyldiphenyl-iodonium hexafluoroarsenate, as disclosed in J Polymr Sci, Polymr Chem Edition (1978), 16(10), 2441-2451; Diaryliodonium salts containing complex metal halide anions such as diphenyliodonium fluoroborate, as disclosed in J Polymr Sci, Poly Sympos (1976), 56, 383-95; and any combination thereof.

Illustrative sulfonium type cationic photoinitiators include, for example, UVI 6992 (sulfonium salt) as disclosed in Japanese patent JP2007126612; compounds of the formula: 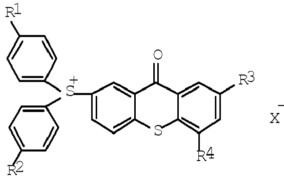 where R¹ and R² = F; R³ = isopropyl; R⁴ = H; X = PF₆, as disclosed in Japanese patent JP10101718; thioxanthone-based sulfonium salts, e.g., of the formula: 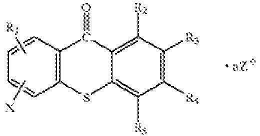 as disclosed in U.S. Patent No. 6,054,501; (Acyloxyphenyl)sulfonium salts of the type R₃₋ₓS⁺R³ₓ A⁻, where A⁻ is a non-nucleophilic anion such as AsF₆⁻, and R³ may be the phenyl group shown below: 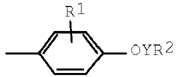 as disclosed in U.S. Patent No. 5,159,088; 9,10-dithiophenoxyanthracene alkyldiarylsulfonium salts, e.g., ethylphenyl(9-thiophenoxy-anthracenyl-10) sulfonium hexafluoroantimonate, and the like, as disclosed in U.S. Patent No. 4,760,013; etc.; triphenylsulfonium hexafluorophosphate salt, as disclosed in U.S. Patent No. 4,245,029; S,S-dimethyl-S-3,5-dimethyl-2-hydroxyphenyl)sulfonium salts, as disclosed in J Poly Sci, Part A (2003), 41(16), 2570-2587; Anthracene-bound sulfonium salts, as disclosed in J Photochem & Photobiology, A: Chemistry (2003), 159(2), 161-171; triarylsulfonium salts, as disclosed in J Photopolymer Science & Tech (2000), 13(1), 117-118 and J Poly Science, Part A (2008), 46(11), 3820-29; S-aryl-S,S-cycloalkylsulfonium salts, as disclosed in J Macromol Sci, Part A (2006), 43(9), 1339-1353; dialkylphenacylsulfonium salts, as disclosed in UV & EB Tech Expo & Conf, May 2-5, 2004, 55-69 and ACS Symp Ser (2003), 847, 219-230; Dialkyl(4-hydroxyphenyl)sulfonium salts, and their isomeric dialkyl(2-hydroxyphenyl)sulfonium salts, as disclosed in ACS 224^{th} Natnl Meeting, August 18-22, 2002, POLY-726; Dodecyl(4-hydroxy-3,5-dimethylphenyl) methylsulfonium hexafluorophosphate and similar alkyl analogs other than dodecyl. Tetrahydro-1-(4-hydroxy-3,5-dimethylphenyl)thiophenium hexafluorophosphate and tetrahydro-1-(2-hydroxy-3,5-dimethylphenyl)thiophenium hexafluorophosphate, as disclosed in ACS Polymer Preprints (2002), 43(2), 918-919; photoinitiators with the general structure Ar'S⁺CH₃(C₁₂H₂₅)SbF₆⁻, where Ar' is phenacyl (I), 2-indanonyl (II), 4-methoxyphenacyl (III), 2-naphthoylmethyl (IV), 1-anthroylmethyl (V), or 1-pyrenoylmethyl (VI), as disclosed in J Polymr Sci, Part A (2000), 38(9), 1433-1442; Triarylsulfonium salts Ar₃S⁺MXₙ⁻ with complex metal halide anions such as BF₄⁻, AsF₆⁻, PF₆⁻, and SbF₆⁻, as disclosed in J Polymr Sci, Part A (1996), 34(16), 3231-3253; Dialkylphenacylsulfonium and dialkyl(4-hydroxyphenyl) sulfonium salts, as disclosed in Macromolecules (1981), 14(5), 1141-1147; Triarylsulfonium salts R²R¹S⁺MFₙ⁻ (R², R¹ = Ph or substituted phenyl; M = B, As, P; n = 4 or 6) and the sulfonium salt of formula (I): 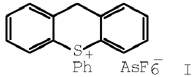 as disclosed in J. Polymr. Sci, Polymr Chem Edition (1979), 17(4), 977-99; aromatic sulfonium salts with, e.g., PF₆⁻ anion, e.g., UVI 6970, as disclosed in JP 2000239648; and any combination thereof.

Suitable pyridinium type cationic photoinitiators include, for example, N-ethoxy 2-methylpyridinium hexafluorophosphate (EMP⁺ PF₆⁻), as disclosed in Turkish J of Chemistry (1993), 17(1), 44-49; Charge-transfer complexes of pyridinium salts and aromatic electron donors (hexamethyl-benzene and 1,2,4-trimethyoxy-benzene), as disclosed in Polymer (1994), 35(11), 2428-31; N,N'-diethoxy-4,4'-azobis(pyridinium) hexafluorophosphate (DEAP), as disclosed in Macromolecular Rapid Comm (2008), 29(11), 892-896; and any combination thereof.

Other suitable cationic photoinitiators include, for example, Acylgermane based photoinitiator in the presence of onium salts, e.g., benzoyltrimethylgermane (BTG) and onium salts, such as diphenyl-iodonium hexafluorophosphate (Ph₂I⁺PF₆⁻) or N-ethoxy-2-methyl-pyridinium hexafluorophosphate (EMP⁺PF₆⁻), as disclosed in Macromolecules (2008), 41(18), 6714-6718; Di-Ph diselenide (DPDS), as disclosed in Macromolecular Symposia (2006), 240, 186-193; N-phenacyl-N,N-dimethyl-anilinium hexafluoroantimonate (PDA⁺SbF₆⁻), as disclosed in Macromol Rapid Comm (2002), 23(9), 567-570; Synergistic blends of: diaryliodonium hexafluoro-antimonate (IA) with tolylcumyl-iodonium tetrakis(pentafluoro-phenyl)borate (IB), and cumenecyclopentadienyliron(II) hexafluorophosphate with IA and IB, as disclosed in Designed Monomers and Polymers (2007), 10(4), 327-345; Diazonium salts, e.g., 4-(hexyloxy)-substituted diazonium salts with complex anions, as disclosed in ACS Symp Series (2003), 847, 202-212; 5-Arylthianthrenium salts, as disclosed in J Poly Sci, Part A (2002), 40(20), 3465-3480; and any combination thereof.

Other suitable cationic photoinitiators include, for example, triarylsulfonium salts such as triarylsulfonium borates modified for absorbing long wavelength UV. Illustrative examples of such modified borates include, for example, SP-300 available from Denka, tris(4-(4-acetylphenyl)thiophenyl)sulfonium tetrakis(pentafluorophenyl)borate, and those photoinitiators disclosed in WO1999028295; WO2004029037; WO2009057600; US6368769 WO2009047105; WO2009047151; WO2009047152; US 20090208872; and US 7611817.

Preferred cationic photoinitiators include a mixture of:
bis[4-diphenylsulfoniumphenyl]sulfide bishexafluoroantimonate;
thiophenoxyphenylsulfonium hexafluoroantimonate (available as Chivacure 1176 from Chitec); tris(4-(4-acetylphenyl)thiophenyl)sulfonium tetrakis(pentafluorophenyl)borate, iodonium,
[4-(1-methylethyl)phenyl](4-methylphenyl)-, tetrakis(pentafluorophenyl)borate (available as Rhodorsil 2074 from Rhodia),
4-[4-(2-chlorobenzoyl)phenylthio]phenylbis(4-fluorophenyl)sulfonium hexafluoroantimonate (as SP-172) and SP-300 (both available from Adeka).

The liquid radiation curable resin composition can include any suitable amount of the cationic photoinitiator, for example, in certain embodiments, in an amount an amount up to about 10 % by weight of the composition, in certain embodiments, up to about 5 % by weight of the composition, and in further embodiments from about 0.2 % to about 5 % by weight of the composition. In a further embodiment, the amount of cationic photoinitiator is from about 0.2 wt% to about 4 wt% of the total composition, and in other embodiments from about 0.5 wt% to about 3 wt%. In an embodiment, the above ranges are particularly suitable for use with epoxy monomers.

In accordance with an embodiment, the liquid radiation curable resin composition can further include a chain transfer agent, particularly a chain transfer agent for a cationic monomer. The chain transfer agent has a functional group containing active hydrogen. Examples of the active hydrogen-containing functional group include an amino group, an amide group, a hydroxyl group, a sulfo group, and a thiol group. In an embodiment, the chain transfer agent terminates the propagation of one type of polymerization, i.e., either cationic polymerization or free-radical polymerization and initiates a different type of polymerization, i.e., either free-radical polymerization or cationic polymerization. In accordance with an embodiment, chain transfer to a different monomer is a preferred mechanism. In embodiments, chain transfer tends to produce branched molecules or crosslinked molecules. Thus, chain transfer offers a way of controlling the molecular weight distribution, crosslink density, thermal properties, and/or mechanical properties of the cured resin composition.

Any suitable chain transfer agent can be employed. For example, the chain transfer agent for a cationic polymerizable component is a hydroxyl-containing compound, such as a compound containing 2 or more than 2 hydroxyl-groups. In an embodiment, the chain transfer agent is selected from the group consisting of a polyether polyol, polyester polyol, polycarbonate polyol, ethoxylated or propoxylated aliphatic or aromatic compounds having hydroxyl groups, dendritic polyols, hyperbranched polyols. An example of a polyether polyol is a polyether polyol comprising an alkoxy ether group of the formula [(CH₂)ₙO]ₘ, wherein n can be 1 to 6 and m can be 1 to 100.

A particular example of a chain transfer agent is polytetrahydrofuran such as TERATHANE^{®} from INVISTA.

The liquid radiation curable resin composition can include any suitable amount of the chain transfer agent, for example, in certain embodiments, in an amount up to about 20 % by weight of the composition, in certain embodiments, up to about 10 % by weight of the composition, and in certain other embodiments from about 5 % to about 12 % by weight of the composition.

The liquid radiation curable resin composition of the invention can further include one or more additives selected from the group consisting of bubble breakers, antioxidants, surfactants, acid scavengers, pigments, dyes, flame retardants, silane coupling agents, ultraviolet absorbers, resin particles, core-shell particle impact modifiers, soluble polymers and block polymers, or organic, inorganic, or organic-inorganic hybrid fillers, in addition to the surface treated glass bubble component, of sizes ranging from 8 nanometers to about 50 microns.

Stabilizers are often added to the compositions in order to prevent a viscosity build-up, for instance a viscosity build-up during usage in a solid imaging process. In an embodiment, stabilizers include those described in U.S. Pat. No. 5,665,792. Such stabilizers are usually hydrocarbon carboxylic acid salts of group IA and IIA metals. In other embodiments, these salts are sodium bicarbonate, potassium bicarbonate, and rubidium carbonate. Rubidium carbonate is preferred for formulations of this invention with recommended amounts varying between 0.0015 to 0.005 % by weight of composition. Solid stabilizers are generally not preferred in filled compositions. A 15∼23 % sodium carbonate solution is preferred for formulations of this invention with recommended amounts varying between 0.05 to 3.0 % by weight of the total composition, more preferably from 0.05 to 1.0 wt%, more preferably from 0.1 to 0.5 % by weight of composition. Alternative stabilizers include polyvinylpyrrolidones and polyacrylonitriles. Other possible additives include dyes, pigments, fillers (e.g. silica particles--preferably cylindrical or spherical silica particles--, talc, glass powder, alumina, alumina hydrate, magnesium oxide, magnesium hydroxide, barium sulfate, calcium sulfate, calcium carbonate, magnesium carbonate, silicate mineral, diatomaceous earth, silica sand, silica powder, titanium oxide, aluminum powder, bronze powder, zinc powder, copper powder, lead powder, gold powder, silver dust, glass fiber, titanic acid potassium whisker, carbon whisker, sapphire whisker, beryllia whisker, boron carbide whisker, silicon carbide whisker, silicon nitride whisker, glass beads, hollow glass beads, metaloxides and potassium titanate whisker), antioxidants, wetting agents, photosensitizers for the free-radical photoinitiator, chain transfer agents, leveling agents, defoamers, surfactants and the like.

In accordance with an embodiment of the invention, the liquid radiation curable resin composition contains the polymerizable components such that the desired photosensitivity is obtained by choosing an appropriate ratio of the initiators and/or polymerizable components. The ratio of the components and of the initiators affect the photosensitivity, speed of curing, degree of curing, crosslink density, thermal properties (e.g., Tg), and/or mechanical properties (e.g., tensile strength, storage modulus, loss modulus) of the liquid radiation curable resin composition or of the cured article.

Some embodiments of liquid radiation curable resins used to form the claimed three-dimensional objects comprise a flame retardant. There are a large number of known flame retardants that are suitable for use with the many of the disclosed liquid radiation curable resins. They include, for example, mineral flame retardants, such as metal hydroxides (especially of aluminum and magnesium), hydroxycarbonates and zinc borates, or halogenated flame retardants, such as tetrabromobisphenol A (TBBPA), polybromodiphenylether (PBDE), hexabromocylcododecane (HBCD) and tetrabromophthalic anhydride (TBPA), halogenated monomors and copolymers etc, or phosophorus-based flame retardants, such as red phosphorus, inorganic phosphates (APP, ammonium polyphosphate), organic phosphorus-based compounds, intumescent flame retardant systems, or nitrogen-based flame retardants (melamine etc), or silicon-based flame retardants, such as silicones, other silicas, organosilane, silsesquioxanes and silicates, or nanoparticles, such as nanoclays, carbon nanotubes and sepiolite, polyhedral oligosilsesquioxane (POSS), metallic oxide particles etc, and combinations of these. Additional examples of specific flame retardants can be found in Materials Science and Engineering R63, 100-125, 2009. In an embodiment, the flame retardant is a Flex B™ series flame retardant available from Applied NanoWorks Inc.

The second aspect of the instant claimed invention is a process for making a three-dimensional article according to claim 14.

In some embodiments, the light source used to cure the liquid radiation curable resin is a laser such as a He-Cd laser or an Argon ion laser or an Nd-YVO₄ solid state laser. Such lasers are common on commercially available stereolithography machines and known in the art. In other embodiments, the light source is a light-emitting diode (LED). In other embodiments, the light source is a lamp. In still further embodiments, the light is delivered to the liquid radiation curable resin using an image produced from a DMD (digital micromirror device) chip or LCD display. The wavelength of the light used to cure the liquid radiation curable resin must overlap sufficiently with the absorption profile of the photoinitiating system.

In some embodiments, depending on the amount of thickener or anti-floating agent used, vigorous mixing of the liquid radiation curable resin maybe required to avoid floating of the filler in some types of additive fabrication processes. For stereolithography processes, the building parameters used to build parts with other filled liquid radiation curable resins, such as NanoTool™, available from DSM, or BlueStone™, available from 3D Systems, may be used to obtain suitable plastic cores. Since the filler may float over time, the higher percentage of filler at the build surface may create issues with the recoating process of a stereolithography machine during the build. Consequently, monitoring of the build is required. The amount of filler floating at the surface depends on amount of material in the vat, the height of the vat, and the amount of time elapsed since the liquid radiation curable resin was mixed.

The plastic core need not be entirely solid to obtain three-dimensional articles that possess excellent mechanical properties. Surprisingly, the strength to weight ratio of the three-dimensional articles may further be improved in some cases by adding some internal structure to the plastic core rather than having an entirely solid structure. Techniques to adjust the internal structure of parts made via additive fabrication processes are well known in the art. For instance, such structures may be formed using the SOMOS^{®} TetraShell software module distributed by DSM or the QuickCast™ module available from 3D Systems. Such techniques create an internal lattice structure within the skin boundary of the part (inside of the external walls of the part). Instead of a fully solid interior, the part possesses an internal lattice structure with a plurality of internal, interconnected cavities. These internal lattice structures greatly reduce the weight of the part while maintaining adequate structural integrity of the part.

There are a variety of suitable lattice structures. For instance, a suitable internal lattice structure for use in a disclosed plastic core embodiment of the invention is a substantially uniform, conformal tetrahedron internal lattice structure as utilized by the SOMOS^{®} TetraShell module. Please see, for instance, US 6641 897. In an embodiment, the plastic core possesses an internal lattice structure, preferably a uniform, conformal tetrahedron internal lattice structure.

The following examples further illustrate the invention but, of course, should not be construed as in any way limiting its scope.

### Examples

These examples illustrate embodiments of the liquid radiation curable resins for additive fabrication of the instant invention. Table 1 lists the various components of the liquid radiation curable resins for additive fabrication used as examples or comparative examples.

**Table 1**

| **Name** | **Function in Formula** | **Chemical Descriptor** | **Supplier** |
|---|---|---|---|
| 4-methoxyphenol | Antioxidant | 4-methoxyphenol | Sigma Aldrich |
| 737BC | Filler | Milled glass fiber | Owens Corning |
| AEROSIL 200 | Thickener | Fumed silica | Evonik |
| NP-30 | Filler | Fused silica | AGC Si-Tech |
| CELLOXIDE 2021P | Cationic Polymerizable Compound | (3',4'-Epoxycyclohexyl methyl) 3,4-epoxycyclohexane carboxylate | Daicel Chemicals |
| CHIVACURE 1176 | Cationic Photoinitiator | A mixture of: bis[4-diphenylsulfonium phenyl] sulfide bishexafluoroantimonate; thiophenoxyphenyl sulfonium hexafluoroantimonate | Chitec |
| DPHA | Radical Polymerizable Compound | Dipentaerythritol hexaacrylate | Shin-Nakamura Chemicals |
| EBECRYL 3700 | Radical Polymerizable Compound | Bisphenol A diglycidyl ether diacrylate | Cytec |
| H50/10,000EPX | Filler | Surface treated glass bubble | 3M |
| HELOXY 68 | Cationic Polymerizable Compound | Neopentylglycol diglycidylether | Hexion |
| IRGACURE 184 | Radical Photoinitiator | 1-Hydroxy-1-cyclohexyl phenyl ketone | BASF |
| NANOCRYL A220 | Filler in reactive monomer | 50 % 15 nm of SiO₂ particle in trimethylolpropane triacrylate | Nanoresins |
| NANOPOX A610 | Filler in reactive monomer | 40 % 15 nm of SiO₂ particle in (3',4'-Epoxycyclohexyl methyl) 3,4-epoxycyclohexane carboxylate | Nanoresins |
| OXT-101 | Cationic Polymerizable Compound | 3-Ethyl-3-oxetanemethanol | Toagosei |
| TERATHANE 1000 | Chain transfer agent | Poly(tetramethylene ether) glycol | Invista |

### Testing of Dispersions

Two dispersions are prepared as listed in Table 2 below. The values presented are percentage by weight of the ingredient with respect to the entire composition. Ex1 describes the formula of an example of the invention. CE1 describes a formula of a comparative example, not to be construed as an example of the invention.

**Table 2**

| | **Ex 1** | **CE1** |
|---|---|---|
| Nanopox A610 | | 25.93 |
| Heloxy 68 | | 5.62 |
| Nanocryl A220 | | 5.03 |
| H50/10,000EPX | 23.33 | |
| DPHA | | 1.55 |
| 737BC | | 29.21 |
| NP-30 | | 29.21 |
| 4-methoxyphenol | 0.02 | 0.01 |
| Irgacure 184 | 0.96 | 0.30 |
| Chivacure 1176 | 0.79 | 3.12 |
| OXT-101 | 6.96 | |
| Celloxide 2021P | 43.71 | |
| Terathane 1000 | 8.46 | |
| Ebecryl 3700 | 14.22 | |
| Aerosil 200 | 1.55 | |
| | | |
| Total | 100 | 100 |
| Total fillers | 23.33 | 71.31 |

In addition to the two dispersions listed above, a third dispersion is also tested. The third dispersion is a commercially available liquid radiation curable resin for additive fabrication sold by DSM under the name NanoTool™. NanoTool™ comprises dense silica filler. The viscosity, working curve data, and tensile properties of NanoTool™ were not specifically tested, but rather obtained from the publically available product data sheet. The NanoTool™ dispersion is listed as CE2 in the following tables.

The viscosity, liquid density, and working curve data for Ex1 and CE1 are measured using the following methods.

The viscosity of a formulation is measured using a Paar Physica LC3 Viscometer operating at a shear rate of 50s-1 and using a Z3 cup, utilizing 13 ml of material per measurement. All viscosity measurements are performed with the viscometer/sample equilibrated to 30 °C.

The liquid density is measured using a weight per gallon cup (available from Gardner/Neotec). All density measurements are performed with the sample equilibrated to 25 °C.

The working curve is a measure of the photospeed of the particular material. It represents the relationship between the thickness of a layer of liquid radiation curable resin produced as a function of the exposure given. For all formulations, the exposure-working curve of the formula is determined using methods well known in the art.

The exposure-working curve for each formulation is measured using a 20 g sample of the formulation in a 100 mm diameter petri dish held at 30 °C and 30 % relative humidity. The surface of the formulation is exposed with a beam from a solid state laser operating at a wavelength of 354.7 nm. The exposures are made in half-inch squares (exposure regions) which are scanned out by drawing consecutive parallel lines approximately 25.4 micron apart on the surface of the liquid in the petri dish at 72 mW. Different exposure regions are exposed to different levels of known incident energy to obtain different cured thicknesses. The spot diameter at the liquid surface is approximately 0.026 cm in diameter. After waiting at least 15 minutes for the exposed panels to harden, the panels are removed from the petri dish and excess, uncured resin is removed by blotting with a Kimwipe EX-L (Kimberly Clark). Film thickness is measured with a Mitutoyo Model ID-C112CE Indicator Micrometer. Film thickness is a linear function of the logarithm of the exposure energy; the slope of the regression is Dp (units of mils) and Ec is the x-axis intercept of the regression fit (units of mJ/cm²). E10 is the amount of energy required to cure a 10 mil thick layer of liquid resin.

Viscosity, liquid density, and working curve data (Ec, Dp, and E10) are presented for Ex1, CE1, and CE2, in Table 3. Ex1 possesses a very low liquid density compared to the comparative examples. Ex1 also possesses acceptable viscosity and working curve data for use in additive fabrication processes that require liquid radiation curable resins.

**Table 3**

| | Ex1 | CE1 | CE2* |
|---|---|---|---|
| Viscosity (30°C, cps) | 2770 | 3100 | ∼2500 |
| Liquid Density (g/cm³) | 0.85 | 1.84 | ∼1.65 |
| Ec (mJ/cm²) | 12.09 | 9.54 | ∼8.3 |
| Dp (mils) | 5.82 | 6.79 | ∼4.3 |
| E10(mJ/cm²) | 67.41 | 41.63 | ∼84 |

| | | | |
|---|---|---|---|
| * obtained from data sheet, as previously discussed | | | |

Dog-bone shaped tensile test specimens are built from each dispersion by the following additive fabrication process. These parts are built using a Coherent AVIA 355-1800 Solid State Laser. The spot diameter is 0.026 cm in the y-direction and 0.025 cm in the x-direction. The frequency is set to 80 kHz giving a laser power of 75 mW at the part. The vat temperature was kept at approximately 30 °C and the ambient humidity was approximately 30 % RH.

The samples are nominally 150 mm long, 10.15 mm wide in their narrow region and 3.8 mm thick. Specimens are cleaned, dried and subjected to 60 minutes of UV postcure (30 minutes on each side). Specimens are placed in an environment controlled at 50 % RH and 23 °C for seven days. Specimens are removed from the controlled environment immediately prior to testing. Width and thickness of each specimen are verified by measuring with a caliper.

Specimens are tested using an MTS Sintech tensile tester following the procedure of ASTM D638M. Samples are held in a set of wedge action grips with serrated faces. Stress is measured with a 28.913 kN load cell and strain is measured with an extensometer set to initial gauge length of 25.4 mm. Stress and strain are recorded at a grip separation speed of 5.08 mm/minute. The average of three specimens is reported. Percent Elongation at Break is measured from the last data point before failure of the sample.

The following tensile data was measured for parts formed from the Ex1 and CE1, and obtained from the product data sheet for the CE2 dispersions. The data is presented in Table 4 below.

**Table 4**

| | Ex1 | CE1 | CE2* |
|---|---|---|---|
| Tensile Strength(MPa) | 48.3 | 53.4 | 70 |
| Tensile Modulus (MPa) | 3481 | 14100 | 11200 |
| Elongation at Break(%) | 1.30 | 0.47 | 0.9 |

| | | | |
|---|---|---|---|
| * obtained from data sheet, as previously discussed | | | |

Dog-bone shaped tensile test specimens (plastic cores) are built according to the procedure mentioned above. A metal shell is then formed over the plastic core by subjecting the parts to an electroforming process known in the art. Before being subjected to the electroforming process the parts are mechanically finished using a combination of manually sanding with sandpaper (less than 600 grit) and vapor honing using an appropriate vapor honing machine. The parts are then washed using isopropanol or water. The electroplating process consists of forming a 1-100 µm nickel base layer via an electroless deposition process, and then forming a nickel outer layer. Three specimens were formed for each data point.

The width and thickness of the narrow section of the plastic specimens are recorded at three locations before plating. The cross-sectional area is calculated for each location by multiplying the width by the thickness. The plastic part is then plated via an electroplating process. Upon completion of the plating process, the width and thickness is again measured at the same locations and the cross-sectional area is again calculated. The percentage by volume of metal coating is then calculated for each location by subtracting the cross-sectional area of the plastic core before plating from the cross-sectional area of the plated part, dividing by the cross-sectional area of the plated part, and multiplying by 100. The metal coating volume for each specimen was calculated by averaging the values for percentage by volume of metal calculated at each of the three measurement locations.

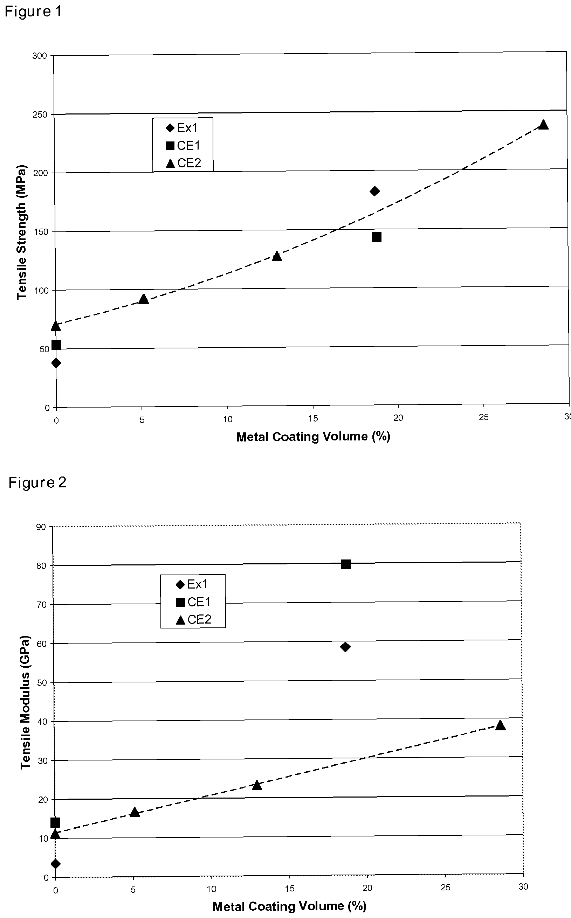

The metal coating volume and the measured tensile properties obtained for each specimen were averaged across the three specimens to obtain the reported tensile properties and metal coating volume percentages. Tensile strength and modulus were measured according to the procedure detailed above. The results for tensile strength are presented in Figure 1. The results for tensile modulus are presented in Figure 2. The presented trend lines are based on the CE2 results only.

Excellent tensile strength and tensile modulus were measured for the Ex1 parts. The excellent tensile properties of the Ex1 parts were attained with a plastic core solid density of less that 0.9 g/cm³, thus producing considerably lighter weight parts than the much denser CE1 and CE2 parts.

Good adhesion of the metal shell to the plastic core was observed for the Ex1 parts. During tensile testing multiple cracking sounds were observed in the CE1 and CE2 parts. Multiple cracks indicate delamination of the metal shell from the plastic core or insufficient adhesion of the metal shell to the plastic core. In contrast, a single crack was observed in the Ex1 parts. A single crack indicates improved adhesion of the metal core to the plastic shell.

## Claims

1. A three-dimensional article having a plastic core and a metal shell, said plastic core being the cured product of a liquid radiation curable resin via an additive fabrication process, said plastic core having a solid density of less than 1.0 g/cm³, preferably less than 0.90 g/cm³, more preferably less than 0.80 g/cm³, and said metal shell being formed by a metal coating process,
and wherein said liquid radiation curable resin comprises 10-35 wt.% of surface treated glass bubbles as filler, wherein said filler has a density of less than 1.0 g/cm³.

2. The three-dimensional article of claim 1 wherein the metal comprises nickel.

3. The three-dimensional article of claim 1 or 2 wherein the three-dimensional article has a tensile strength of greater than 90 MPa and a tensile modulus of greater than 25 GPa.

4. The three-dimensional article of any one of claims 1 through 3 wherein the metal shell comprises from 5 % to 30 %, more preferably from 10 % to 20 %, of the volume of the three-dimensional article.

5. The three-dimensional article of any one of claims 1 through 4 wherein the thickness of the metal shell is from 0.05 mm to 3.0 mm in thickness, preferably from 0.05 mm to 1.5 mm.

6. The three-dimensional article of any one of claims 1 through 5 wherein the metal shell comprises a base layer, preferably comprising copper or nickel, with a thickness of from 1 µm to 100 µm.

7. The three-dimensional article of any one of claims 1 through 6 wherein, said filler has a density of less than 0.75 g/cm³.

8. The three-dimensional article of any one of claims 1 through 7 wherein said liquid radiation curable resin comprises
a. from 10 wt.% to 35 wt.% of surface treated glass bubbles
b. from 5 wt.% to 25 wt.% of one or more free-radically polymerizable compounds;
c. from 0.2 wt.% to 5 wt.% of one or more free-radical polymerization initiators;
d. from 30 wt.% to 75 wt.% of one or more cationically polymerizable compounds; and
e. from 0.2 wt.% to 5 wt.% of one or more cationic polymerization initiators.

9. The three-dimensional article of any one of claims 1 through 8 wherein the surface treated glass bubbles have an average particle diameter of from 0.1 micron to 100 micron.

10. The three-dimensional article of any one of claims 1 through 9 wherein the liquid radiation curable resin further comprises
f. a thickener, said thickener preferably being fumed silica, present in an amount from 0.2 wt.% to 10 wt.%; and/or
g. a flame retardant.

11. The three-dimensional article of any one of claims 8 through 10 wherein the surface treated glass bubbles comprise surface treated soda lime borosilicate glass and/or wherein the surface treated glass bubbles are surface treated with a silane.

12. The three-dimensional article of any one of claims 1 through 11 wherein the plastic core is formed via a stereolithography process.

13. The three-dimensional article of any one of claims 1 through 12 wherein the plastic core possesses an internal lattice structure.

14. A process for making a three-dimensional article, preferably according to any one of claims 1-13, comprising the steps of
(1) coating a layer of a liquid radiation curable resin having a liquid density of less than 1.0 g/cm³, preferably less than 0.90 g/cm³, more preferably less than 0.80 g/cm³, onto a surface;
(2) exposing said layer imagewise to actinic radiation to form a first exposed imaged cross-section, wherein the radiation is of sufficient intensity and time to cause substantial curing of the layer in the exposed areas;
(3) coating an additional layer of the liquid radiation curable resin onto the previously exposed imaged cross-section;
(4) exposing said additional layer imagewise to actinic radiation to form an additional imaged cross-section, wherein the radiation is of sufficient intensity and time to cause substantial curing of the second layer in the exposed areas and to cause adhesion to the previously exposed imaged cross-section;
(5) repeating steps (3) and (4) a desired number of times to build up the three-dimensional article;
(6) preferably pickling the three-dimensional article, wherein said pickling is preferably performed by a physical process rather than a chemical process; and
(7) forming a metal shell on the three-dimensional article via an electroforming process,
wherein said liquid radiation curable resin comprises 10-35 wt.% of surface treated glass bubbles as filler, wherein said filler has a density of less than 1.0 g/cm³.

15. The process of claim 14 wherein said liquid radiation curable resin has a dynamic viscosity at 30 °C of less than 5 Pa·s (5000 cps), preferably less than 4 Pa·s (4000 cps), more preferably less than 3 Pa·s (3000 cps).

## Patentansprüche

1. Dreidimensionaler Gegenstand mit einem Kunststoffkern und einer Metallhülle, wobei der Kunststoffkern das gehärtete Produkt eines flüssigen strahlenhärtbaren Harzes über ein additives Herstellungsverfahren ist, wobei der Kunststoffkern eine Feststoffdichte von weniger als 1,0 g/cm³ aufweist, vorzugsweise weniger als 0,90 g/cm³, bevorzugter weniger als 0,80 g/cm³, und die Metallhülle durch ein Metallbeschichtungsverfahren gebildet ist,
und wobei das flüssige strahlenhärtbare Harz 10-35 Gew.-% an oberflächenbehandelten Glasbläschen als Füllstoff umfasst, wobei der Füllstoff eine Dichte von weniger als 1,0 g/cm³ aufweist.

2. Dreidimensionaler Gegenstand gemäß Anspruch 1, wobei das Metall Nickel umfasst.

3. Dreidimensionaler Gegenstand gemäß Anspruch 1 oder 2, wobei der dreidimensionale Gegenstand eine Zugfestigkeit von größer als 90 MPa und einen Zugmodul von größer als 25 GPa aufweist.

4. Dreidimensionaler Gegenstand gemäß einem der Ansprüche 1 bis 3, wobei die Metallhülle von 5 % bis 30 %, bevorzugter von 10 % bis 20 %, des Volumens des dreidimensionalen Gegenstands umfasst.

5. Dreidimensionaler Gegenstand gemäß einem der Ansprüche 1 bis 4, wobei die Dicke der Metallhülle von 0,05 mm bis 3,0 mm beträgt, vorzugsweise von 0,05 mm bis 1,5 mm.

6. Dreidimensionaler Gegenstand gemäß einem der Ansprüche 1 bis 5, wobei die Metallhülle eine Basisschicht, die vorzugsweise Kupfer oder Nickel umfasst, mit einer Dicke von 1 µm bis 100 µm umfasst.

7. Dreidimensionaler Gegenstand gemäß einem der Ansprüche 1 bis 6, wobei der Füllstoff eine Dichte von weniger als 0,75 g/cm³ aufweist.

8. Dreidimensionaler Gegenstand gemäß einem der Ansprüche 1 bis 7, wobei das flüssige strahlenhärtbare Harz umfasst:
a. von 10 Gew.-% bis 35 Gew.-% an oberflächenbehandelten Glasbläschen,
b. von 5 Gew.-% bis 25 Gew.-% an einer oder mehreren frei-radikalisch polymerisierbaren Verbindungen;
c. von 0,2 Gew.-% bis 5 Gew.-% an einem oder mehreren Initiatoren der frei-radikalischen Polymerisation;
d. von 30 Gew.-% bis 75 Gew.-% an einer oder mehreren kationisch polymerisierbaren Verbindungen; und
e. von 0,2 Gew.-% bis 5 Gew.-% an einem oder mehreren Initiatoren der kationischen Polymerisation.

9. Dreidimensionaler Gegenstand gemäß einem der Ansprüche 1 bis 8, wobei die oberflächenbehandelten Glasbläschen einen mittleren Partikeldurchmesser von 0,1 Mikrometer bis 100 Mikrometer aufweisen.

10. Dreidimensionaler Gegenstand gemäß einem der Ansprüche 1 bis 9, wobei das flüssige strahlenhärtbare Harz ferner umfasst:
f. ein Verdickungsmittel, wobei das Verdickungsmittel vorzugsweise pyrogenes Siliciumdioxid ist, in einer Menge von 0,2 Gew.-% bis 10 Gew.-% vorhanden; und/oder
g. einen Flammhemmer.

11. Dreidimensionaler Gegenstand gemäß einem der Ansprüche 8 bis 10, wobei die oberflächenbehandelten Glasbläschen oberflächenbehandeltes Natronkalk-Borsilicatglas umfassen und/oder wobei die oberflächenbehandelten Glasbläschen mit einem Silan oberflächenbehandelt sind.

12. Dreidimensionaler Gegenstand gemäß einem der Ansprüche 1 bis 11, wobei der Kunststoffkern durch ein Stereolithographieverfahren gebildet ist.

13. Dreidimensionaler Gegenstand gemäß einem der Ansprüche 1 bis 12, wobei der Kunststoffkern eine interne Gitterstruktur aufweist.

14. Verfahren zum Herstellen eines dreidimensionalen Gegenstands, vorzugsweise gemäß einem der Ansprüche 1-13, umfassend die Schritte
(1) Aufschichten einer Schicht aus einem flüssigen strahlenhärtbaren Harz mit einer Flüssigkeitsdichte von weniger als 1,0 g/cm³, vorzugsweise weniger als 0,90 g/cm³, bevorzugter weniger als 0,80 g/cm³, auf eine Oberfläche;
(2) bildweises Exponieren der Schicht gegenüber aktinischer Strahlung, um einen ersten exponierten, abgebildeten Querschnitt zu bilden, wobei die Strahlung von ausreichender Intensität und Dauer ist, um in den exponierten Bereichen wesentliche Härtung der Schicht zu bewirken;
(3) Aufschichten einer zusätzlichen Schicht des flüssigen strahlenhärtbaren Harzes auf den zuvor exponierten abgebildeten Querschnitt;
(4) bildweises Exponieren der zusätzlichen Schicht gegenüber aktinischer Strahlung, um einen zusätzlichen Querschnitt zu bilden, wobei die Strahlung von ausreichender Intensität und Dauer ist, um wesentliches Härten der zweiten Schicht in den exponierten Bereichen zu bewirken und um Haften an den zuvor exponierten abgebildeten Querschnitt zu bewirken;
(5) Wiederholen der Schritte (3) und (4) so oft wie gewünscht, um den dreidimensionalen Gegenstand aufzubauen;
(6) vorzugsweise Beizen des dreidimensionalen Gegenstands, wobei das Beizen vorzugsweise durch ein physikalisches Verfahren und nicht durch ein chemisches Verfahren durchgeführt wird; und
(7) Bilden einer Metallhülle auf dem dreidimensionalen Gegenstand über ein Elektroformverfahren,
wobei das flüssige strahlenhärtbare Harz 10-35 Gew.-% an oberflächenbehandelten Glasbläschen als Füllstoff umfasst, wobei der Füllstoff eine Dichte von weniger als 1,0 g/cm³ aufweist.

15. Verfahren gemäß Anspruch 14, wobei das flüssige strahlenhärtbare Harz eine dynamische Viskosität bei 30 °C von weniger als 5 Pa.s (5000 cps) aufweist, vorzugsweise weniger als 4 Pa.s (4000 cps), bevorzugter weniger als 3 Pa.s (3000 cps).

## Revendications

1. Article tridimensionnel ayant un coeur plastique et une coquille métallique, ledit coeur plastique étant le produit durci d'une résine liquide durcissable par rayonnement par un procédé de fabrication additive, ledit coeur plastique ayant une masse volumique solide inférieure à 1,0 g/cm³, de préférence inférieure à 0,90 g/cm³, mieux encore inférieure à 0,80 g/cm³, et ladite coquille métallique étant formée par un procédé de dépôt de métal, et dans lequel ladite résine liquide durcissable par rayonnement comprend 10-35 % en poids de bulles de verre traitées en surface comme charge, ladite charge ayant une masse volumique inférieure à 1,0 g/cm³.

2. Article tridimensionnel de la revendication 1 dans lequel le métal comprend du nickel.

3. Article tridimensionnel de la revendication 1 ou 2, l'article tridimensionnel ayant une résistance à la traction supérieure à 90 MPa et un module de traction supérieur à 25 GPa.

4. Article tridimensionnel de l'une quelconque des revendications 1 à 3 dans lequel la coquille métallique constitue de 5 % à 30 %, mieux encore de 10 % à 20 % du volume de l'article tridimensionnel.

5. Article tridimensionnel de l'une quelconque des revendications 1 à 4 dans lequel l'épaisseur de la coquille métallique est de 0,05 mm à 3,0 mm, de préférence de 0,05 mm à 1,5 mm.

6. Article tridimensionnel de l'une quelconque des revendications 1 à 5 dans lequel la coquille métallique comprend une couche de base, comprenant de préférence du cuivre ou du nickel, avec une épaisseur de 1 µm à 100 µm.

7. Article tridimensionnel de l'une quelconque des revendications 1 à 6 dans lequel ladite charge a une masse volumique inférieure à 0,75 g/cm³.

8. Article tridimensionnel de l'une quelconque des revendications 1 à 7 dans lequel ladite résine liquide durcissable par rayonnement comprend
a. de 10 % en poids à 35 % en poids de bulles de verre traitées en surface ;
b. de 5 % en poids à 25 % en poids d'un ou plusieurs composés polymérisables par voie radicalaire ;
c. de 0,2 % en poids à 5 % en poids d'un ou plusieurs initiateurs de polymérisation radicalaire ;
d. de 30 % en poids à 75 % en poids d'un ou plusieurs composés polymérisables par voie cationique ; et
e. de 0,2 % en poids à 5 % en poids d'un ou plusieurs initiateurs de polymérisation cationique.

9. Article tridimensionnel de l'une quelconque des revendications 1 à 8 dans lequel les bulles de verre traitées en surface ont un diamètre moyen de particules de 0,1 micromètre à 100 micromètres.

10. Article tridimensionnel de l'une quelconque des revendications 1 à 9 dans lequel la résine liquide durcissable par rayonnement comprend en outre f. un épaississant, ledit épaississant étant de préférence de la silice pyrogénée, présente dans une quantité de 0,2 % en poids à 10 % en poids ; et/ou g. un ignifugeant.

11. Article tridimensionnel de l'une quelconque des revendications 8 à 10 dans lequel les bulles de verre traitées en surface comprennent du verre de borosilicate sodocalcique traité en surface et/ou dans lequel les bulles de verre traitées en surface sont traitées en surface avec un silane.

12. Article tridimensionnel de l'une quelconque des revendications 1 à 11 dans lequel le coeur plastique est formé par un procédé de stéréolithographie.

13. Article tridimensionnel de l'une quelconque des revendications 1 à 12 dans lequel le coeur plastique possède une structure de réseau interne.

14. Procédé de fabrication d'un article tridimensionnel, de préférence selon l'une quelconque des revendications 1 à 13, comprenant les étapes consistant à
(1) déposer une couche d'une résine liquide durcissable par rayonnement, ayant une masse volumique liquide inférieure à 1,0 g/cm³, de préférence inférieure à 0,90 g/cm³, mieux encore inférieure à 0,80 g/cm³, sur une surface ;
(2) exposer ladite couche selon une image à un rayonnement actinique pour former une première section transversale imagée exposée, le rayonnement étant d'une intensité et d'un temps suffisants pour provoquer un durcissement substantiel de la couche dans les zones exposées ;
(3) déposer une couche supplémentaire de la résine liquide durcissable par rayonnement sur la section transversale imagée précédemment exposée ;
(4) exposer ladite couche supplémentaire selon une image à un rayonnement actinique pour former une section transversale imagée supplémentaire, le rayonnement étant d'une intensité et d'un temps suffisants pour provoquer un durcissement substantiel de la deuxième couche dans les zones exposées et pour provoquer une adhésion à la section transversale imagée précédemment exposée ;
(5) répéter les étapes (3) et (4) un nombre souhaité de fois pour constituer l'article tridimensionnel ;
(6) de préférence, décaper l'article tridimensionnel, ledit décapage étant de préférence effectué par un procédé physique plutôt que par un procédé chimique ; et
(7) former une coquille métallique sur l'article tridimensionnel par un procédé d'électroformage,
dans lequel ladite résine liquide durcissable par rayonnement comprend 10-35 % en poids de bulles de verre traitées en surface comme charge, ladite charge ayant une masse volumique inférieure à 1,0 g/cm³.

15. Procédé de la revendication 14 dans lequel ladite résine liquide durcissable par rayonnement a une viscosité dynamique à 30 °C inférieure à 5 Pa·s (5000 cP), de préférence inférieure à 4 Pa·s (4000 cP), mieux encore inférieure à 3 Pa·s (3000 cP).
